(19) Europäisches Patentamt
European Patent Office
Office européen des brevets

(11) Veröffentlichungsnummer: **0 239 782 B1**

(12) # EUROPÄISCHE PATENTSCHRIFT

(45) Veröffentlichungstag der Patentschrift: **26.06.91**

(51) Int. Cl.$^5$: **G03F 7/09**, G03F 7/004

(21) Anmeldenummer: **87102556.5**

(22) Anmeldetag: **24.02.87**

(54) **Lichtempfindliches Aufzeichnungselement.**

(30) Priorität: **27.02.86 DE 3606266**

(43) Veröffentlichungstag der Anmeldung:
**07.10.87 Patentblatt 87/41**

(45) Bekanntmachung des Hinweises auf die Patenterteilung:
**26.06.91 Patentblatt 91/26**

(84) Benannte Vertragsstaaten:
**AT BE CH DE ES FR GB IT LI NL SE**

(56) Entgegenhaltungen:
**AU-A- 407 282**
**US-A- 4 370 405**

**MICROELECTRONIC ENGINEERING**, Band 3, Nr. 1/4, Dezember 1985, Seiten 321-328, Elsevier Science Publishers B.V., Amsterdam, NL; M. BOLSEN: "To dye or not to dye - Some aspects of today's resist technology"

(73) Patentinhaber: **BASF Aktiengesellschaft**
**Carl-Bosch-Strasse 38**
**W-6700 Ludwigshafen(DE)**

(72) Erfinder: **Wallbillich, Guenter, Dr.**
**Erschigweg 19**
**W-6730 Neustadt(DE)**
Erfinder: **Neumann, Peter, Dr.**
**Franz-Schubert-Strasse 1**
**W-6908 Wiesloch(DE)**
Erfinder: **Hansen, Guenter, Dr.**
**Alwin-Mittasch-Platz 8**
**W-6700 Ludwigshafen(DE)**

**EP 0 239 782 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein lichtempfindliches Aufzeichnungselement, insbesondere für die Herstellung von Druck-, Reliefformen oder Resistmustern, mit einem dimensionsstabilen Träger, einer darauf aufgebrachten, festen lichtempfindlichen Aufzeichnungsschicht sowie gegebenenfalls einer oder mehreren Zwischenschichten zwischen Träger und lichtempfindlicher Aufzeichnungsschicht, welches in der lichtempfindlichen Aufzeichnungsschicht bzw. - sofern zwischen Träger und lichtempfindlicher Aufzeichnungsschicht eine oder mehrere Zwischenschichten vorhanden sind - in der lichtempfindlichen Aufzeichnungsschicht und/oder mindestens einer der Zwischenschichten einen Farbstoff enthält.

Lichtempfindliche Aufzeichnungselemente der genannten Art finden in der Reproduktionstechnik, z.B. bei der Herstellung von Druck- oder Reliefformen sowie von Resistmustern, Anwendung. Als dimensionsstabile Träger dienen üblicherweise Kunststoff-Filme oder -Folien bzw. Stahl-oder Aluminiumbleche; für lichtempfindliche Resistschichten kommen als Träger auch andere Substrate, wie z.B. Kupfer, kupferkaschierte Basiselemente, Leiterplatten, Halbleiterelemente und dergleichen, zur Anwendung. Die einlagig oder auch mehrlagig ausgestaltete lichtempfindliche Aufzeichnungsschicht kann aus einem fotoabbaubaren Material gebildet werden, wodurch sie bei Bestrahlung mit aktinischem Licht in Lösungsmitteln löslich wird, in denen sie vorher unlöslich war; sie kann gleichermaßen auch aus einem fotopolymerisierbaren Gemisch aufgebaut sein, in welchem bei Bestrahlung mit aktinischem Licht durch fotoinitiierte Polymerisation und Vernetzung eine Eigenschaftsdifferenzierung zwischen unbelichteten und belichteten Bereichen erzeugt wird, die für die Entwicklung der Druck-oder Reliefform bzw. des Resistmusters ausgenützt werden kann. Vielfach enthalten die lichtempfindlichen Aufzeichnungselemente, insbesondere wenn sie zur Herstellung von Druck- oder Reliefformen eingesetzt werden, zwischen Träger und lichtempfindlicher Aufzeichnungsschicht eine oder mehrere Zwischenschichten, die z.B. als Haft- und/oder Lichthofschutzschichten ausgebildet und gleichermaßen lichtempfindlich oder lichtunempfindlich sein können.

Zur Steuerung der fotochemischen Prozesse bei der Bildherstellung, beispielsweise zur Erzielung einer bestimmten, gewünschten Reliefstruktur, enthalten die bekannten lichtempfindlichen Aufzeichnungselemente in aller Regel in der lichtempfindlichen Aufzeichnungsschicht und/oder -sofern vorhanden - in der oder mindestens einer der Zwischenschichten Farbstoffe oder Pigmente, die im Wellenlängenbereich des für die lichtempfindliche Aufzeichnungsschicht aktinischen Lichtes absorbieren (vgl. u.a. US-A-2 791 504, GB-A-1 001 831, DE-A-26 58 422, DE-A-22 02 360 und US-A-4 173 673). Pigmente haben hierbei den Nachteil, daß sie häufig unerwünschte Lichtstreuung verursachen oder zum Teil nur schwierig in homogener, gleichmäßiger Verteilung in der betreffenden Schicht eingemischt werden können. Daher werden für die Steuerung der Belichtungs- und anderen fotochemischen Eigenschaften der lichtempfindlichen Aufzeichnungselemente vielfach Farbstoffe bevorzugt. Es hat sich jedoch herausgestellt, daß viele der an sich in Betracht kommenden und für diesen Zweck auch beschriebenen Farbstoffe nicht migrationsbeständig sind, d.h., sind solche Farbstoffe in den verschiedenen Schichten der lichtempfindlichen Aufzeichnungselemente in abgestufter Konzentration enthalten, so wandern die Farbstoffe entsprechend dem Konzentrationsgefälle unter Ausgleich der verschiedenen Konzentrationen und somit auch in aller Regel unter Änderung bzw. Verlust der gezielt eingestellten fotochemischen Eigenschaften der lichtempfindlichen Aufzeichnungselemente. Es sind zwar auch schon nicht-wandernde Farbstoffe für lichtempfindliche Aufzeichnungselemente beschrieben worden; die Farbstoffe, die tatsächlich die gewünschte Migrationsbeständigkeit aufweisen, sind jedoch nach Art und Anzahl sehr gering. Es besteht somit nach wie vor ein Bedarf an migrationsechten Farbstoffen für den Einsatz in lichtempfindlichen Aufzeichnungselementen zur Steuerung der fotochemischen Prozesse bei deren Belichtung.

Aufgabe der vorliegenden Erfindung war es dementsprechend, lichtempfindliche Aufzeichnungselemente der in Rede stehenden Art mit sehr guten Belichtungseigenschaften und hoher Lagerbeständigkeit aufzuzeigen, die in ihrer lichtempfindlichen Aufzeichnungsschicht und/oder einer gegebenenfalls zwischen dimensionsstabilem Träger und lichtempfindlicher Aufzeichnungsschicht vorhandenen Zwischenschicht Farbstoffe für die Steuerung der fotochemischen Eigenschaften dieser lichtempfindlichen Aufzeichnungselemente enthalten, wobei die Farbstoffe in den verschiedenen Schichten der lichtempfindlichen Aufzeichnungselemente in abgestufter Konzentration enthalten sein können, ohne daß es selbst bei langen Lagerzeiten zu einer Farbstoffmigration und damit bedingten Änderung der fotochemischen und Belichtungseigenschaften der lichtempfindlichen Aufzeichnungselemente kommt.

Es wurde nun überraschend gefunden, daß diese Aufgabe durch lichtempfindliche Aufzeichnungselemente gelöst wird, die in ihrer lichtempfindlichen Aufzeichnungsschicht und/oder einer gegebenenfalls zwischen dimensionsstabilem Träger und lichtempfindlicher Aufzeichnungsschicht vorhandenen Zwischenschicht spezielle, Sulfogruppen enthaltende Azo- oder Azoxi-Farbstoffe der nachstehend näher definierten Art enthalten.

Gegenstand der Erfindung ist dementsprechend ein lichtempfindliches Aufzeichnungselement, insbesondere für die Herstellung von Druck-, Reliefformen oder Resistmustern, mit

(a) einem dimensionsstabilen Träger,

(b) einer auf dem Träger aufgebrachten, festen lichtempfindlichen Aufzeichnungsschicht,

sowie gegebenenfalls

(c) einer oder mehreren Zwischenschichten zwischen dem Träger und der lichtempfindlichen Aufzeichnungsschicht,

das in der lichtempfindlichen Aufzeichnungsschicht bzw. für den Fall, daß eine oder mehrere Zwischenschichten vorhanden sind, in der lichtempfindlichen Aufzeichnungsschicht und/oder mindestens einer der Zwischenschichten einen Farbstoff enthält. Das erfindungsgemäße lichtempfindliche Aufzeichnungselement ist dadurch gekennzeichnet, daß als Farbstoff eine Verbindung der allgemeinen Formel (I)

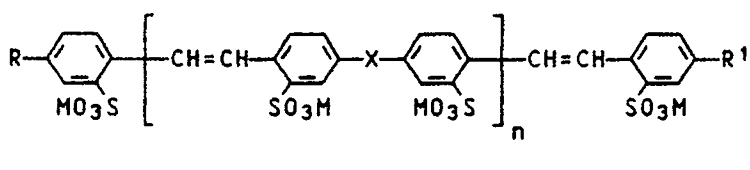

(I)

enthalten ist, worin bedeuten

X : eine Azo- oder Azoxigruppierung,

M : ein Wasserstoffatom, ein Alkalimetall-Kation, das Ammonium- oder ein Amin-Kation,

R, $R^1$ : gleich oder verschieden und unabhängig voneinander, eine $-NO_2$-Gruppe, eine $NH_2$-Gruppe, eine $-NHCOR^2$-Gruppe (mit $R^2$ = einem Wasserstoffatom, einem gegebenenfalls substituierten Alkylrest, einem gegebenenfalls substituierten Cycloalkylrest, einem gegebenenfalls substituierten Phenylrest, einem Alkoxyrest, einem Phenoxyrest, einem 5- oder 6-gliedrigen heteroaromatischen Rest, einer $NH_2$-Gruppe oder einer -COOH-Gruppe), eine $-NHSO_2R^3$-Gruppe (mit $R^3$ = einem Alkyl- oder Phenylrest) oder eine $-N=N-R^4$-Gruppe (mit $R^4$ = dem Rest einer Kupplungskomponente),

n : eine ganze Zahl von 1 bis 6 und für den Fall, daß R und/oder $R^1$ eine $-N=N-R^4$-Gruppe darstellen, auch 0.

Es hat sich überraschenderweise gezeigt, daß die erfindungsgemäß einzusetzenden, speziellen Sulfogruppen enthaltenden Azo- bzw. Azoxi-Farbstoffe in den lichtempfindlichen Aufzeichnungselementen äußerst migrationsbeständig sind und mit großem Vorteil zur Einstellung der Lichtempfindlichkeit, der Belichtungseigenschaften und zur sonstigen Steuerung der fotochemischen Prozesse in den lichtempfindlichen Aufzeichnungselementen bei deren Belichtung mit aktinischem Licht eingesetzt werden können. Die erfindungsgemäßen lichtempfindlichen Aufzeichnungselemente zeichnen sich ferner durch eine hohe Lagerfähigkeit aus, ohne daß hierbei die gewünschten und speziell eingestellten Belichtungs- und Bildreproduktionseigenschaften beeinträchtigt oder verändert werden.

Die Einstellung gezielter Belichtungs- und Bildreproduktionseigenschaften der erfindungsgemäßen lichtempfindlichen Aufzeichnungselemente bzw. die gezielte Steuerung der fotochemischen Prozesse in den erfindungsgemäßen lichtempfindlichen Aufzeichnungselementen bei deren Bestrahlung mit aktinischem Licht mittels der erfindungsgemäß einzusetzenden Farbstoffe kann dabei in mannigfacher Weise erfolgen.

Beispielsweise ist es möglich, daß die erfindungsgemäß einzusetzenden Farbstoffe allein in der lichtempfindlichen Aufzeichnungsschicht der lichtempfindlichen Aufzeichnungselemente in über die Dicke der lichtempfindlichen Aufzeichnungsschicht hinweg abgestufter Konzentration vorliegen. Die Konzentration der Farbstoffe kann dabei von der äußeren Oberfläche der lichtempfindlichen Aufzeichnungsschicht zum Träger hin zu-oder auch abnehmen. Die lichtempfindliche Aufzeichnungsschicht kann dabei einlagig sein oder auch aus mehreren Lagen mit differenzierten Eigenschaften und unterschiedlichen Farbstoffkonzentrationen bestehen.

In lichtempfindlichen Aufzeichnungselementen, die zwischen dimensionsstabilem Träger und lichtempfindlicher Aufzeichnungsschicht eine Zwischenschicht, beispielsweise eine Haft- und/oder Lichthofschutzschicht, enthalten, kann der erfindungsgemäß einzusetzende Farbstoff allein in der lichtempfindlichen Aufzeichnungsschicht oder insbesondere allein in dieser Zwischenschicht vorhanden sein oder aber sowohl in der lichtempfindlichen Aufzeichnungsschicht als auch in der Zwischenschicht in abgestufter Konzentration vorliegen. Im letztgenannten Fall wird in der Regel die Konzentration des erfindungsgemäß einzusetzenden Farbstoffs in der Zwischenschicht höher sein als in der lichtempfindlichen Aufzeichnungsschicht. Es ist selbstverständlich auch möglich, die Belichtungseigenschaften der erfindungsgemäßen lichtempfindlichen

Aufzeichnungselemente bzw. die Steuerung der fotochemischen Prozesse in den erfindungsgemäßen lichtempfindlichen Aufzeichnungselementen bei deren Belichtung mit aktinischem Licht nicht nur über die Konzentration, sondern auch über die Art der Farbstoffe zu steuern, indem man z.B. in den verschiedenen Schichten der lichtempfindlichen Aufzeichnungselemente bzw. den einzelnen Lagen einer mehrlagig ausgestalteten lichtempfindlichen Aufzeichnungsschicht unterschiedlich absorbierende Farbstoffe der erfindungsgemäß zu verwendenden Art inkorporiert.

Als Farbstoffe sind erfindungsgemäß in der lichtempfindlichen Aufzeichnungsschicht und/oder einer zwischen dimensionsstabilem Träger und lichtempfindlicher Aufzeichnungsschicht gegebenenfalls vorhandenen Zwischenschicht der lichtempfindlichen Aufzeichnungselemente solche der vorstehend angegebenen allgemeinen Formel (I) enthalten. Hierin stehen X für eine -N=N- oder eine -N(O)=N-Gruppe und M für ein Wasserstoffatom bzw. Proton, ein Alkalimetall-Kation, insbesondere das Lithium-, Natrium-oder Kalium-Kation, das $NH_4^+$ -Kation oder ein Amin-Kation, wie insbesondere ein $H_2N^{\oplus}R^5R^6$- oder ein $HN^{\oplus}R^5R^6R^7$-Kation, worin die Reste $R^5$ und $R^6$ bzw. $R^5$, $R^6$ und $R^7$ gleich oder verschieden sein können und jeweils für eine Alkylgruppe, insbesondere mit 1 bis 4 C-Atomen, oder eine Hydroxyalkylgruppe, insbesondere mit 2 bis 3 C-Atomen, stehen. Als Beispiele für bevorzugte Amin-Kationen seien angeführt: $H_2N^{\oplus}(C_2H_5)_2$, $H_2N^{\oplus}(CH_3)CH_2CH_2OH$, $H_2N^{\oplus}(CH_2CH_2OH)_2$, $HN^{\oplus}(CH_2CH_2OH)_3$ und $HN^{\oplus}(CH_2\text{-}CHOH\text{-}CH_3)_3$.

Die Reste R und $R^1$ in der allgemeinen Formel (I) können gleich oder verschieden sein und stehen, unabhängig voneinander, insbesondere für eine $NO_2$- oder eine $NH_2$-Gruppe. Ferner können sie auch einen Rest der Formel $-NHCOR^2$ darstellen. Hierin steht $R^2$ insbesondere für ein Wasserstoffatom, einen linearen oder verzweigten Alkylrest, vorzugsweise mit 1 bis 8 Kohlenstoffatomen, wie insbesondere Methyl oder Ethyl, einen substituierten Alkylrest der vorstehend genannten Art, wie z.B. eine Benzylgruppe, eine Methoxymethylgruppe oder eine Phenoxymethylgruppe, für einen Cycloalkylrest, insbesondere die Cyclohexyl-Gruppe, für einen Phenylrest oder einen substituierten Phenylrest, der beispielsweise durch eine oder zwei Alkylgruppen, insbesondere mit 1 bis 4 C-Atomen, Alkoxy-Gruppen, insbesondere mit 1 bis 2 C-Atomen, Hydroxy-Gruppen, Halogenatome, insbesondere Fluor-, Chlor- oder Bromatome, durch eine Amino-, Nitro-, Cyano- oder Trifluoromethyl-Gruppe, durch eine $COOR^8$-Gruppe (mit $R^8$ gleich einem Wasserstoffatom oder einer Alkylgruppe, insbesondere mit 1 bis 4 C-Atomen), durch eine $-SO_2R^9$-Gruppe (mit $R^9$ gleich einem Methyl-, Ethyl-oder Phenylrest), durch eine oder zwei $-SO_2NR^{10}R^{11}$-Gruppen (mit $R^{10}$ und $R^{11}$ gleich oder verschieden und unabhängig voneinander einem Wasserstoffatom, einer Alkyl-Gruppe, insbesondere mit 1 bis 4 C-Atomen, einer Hydroxyalkyl-Gruppe, insbesondere mit 2 bis 3 C-Atomen, oder einer Phenylgruppe), oder durch einen $-SO_3M$-, $PO_3HM$- oder $-PO_3M_2$-Rest (wobei M die oben angegebene Bedeutung hat) oder auch durch eine $-NH\text{-}CO\text{-}C_6H_5\text{-}NH_2$-Gruppe substituiert sein kann, für einen heteroaromatischen, insbesondere 5-oder 6-gliedrigen Ring, wie beispielsweise einen Furyl-, 2,5-Dimethylfuryl-, Thienyl- oder Pyridylrest, für eine Alkoxygruppe, insbesondere mit 1 bis 4 C-Atomen, für eine Phenoxy-Gruppe, für eine $NH_2$-Gruppe oder für eine Carboxyl-Gruppe. Die Reste R und $R^1$ in der allgemeinen Formel (I) können darüber hinaus auch einen Rest der Formel $-NHSO_2R^3$ bedeuten, wobei $R^3$ für eine Alkylgruppe, vorzugsweise mit 1 bis 4 C-Atomen, wie insbesondere Methyl oder Ethyl, oder eine Phenylgruppe, die durch Alkylreste, insbesondere mit 1 bis 4 C-Atomen, wie etwa Methyl, substituiert sein kann, steht. Darüber hinaus können die Reste R und $R^1$ in der allgemeinen Formel (I) insbesondere auch eine $-N=N\text{-}R^4$-Gruppe darstellen, wobei $R^4$ für den Rest einer, vorzugsweise wasserlöslichen, Kupplungskomponente steht. Als Kupplungskomponenten, von denen sich der Rest $R^4$ ableitet, kommen z.B. Verbindungen der Benzol-, Naphthalin-, Pyrazolon-, Pyrazol-, Acetoacetarylid-, Barbitursäure-, Indol-, Benzimidazol-, Benzthiazol-, Chinolon-, Homophthalimid- oder Pyridonreihe in Betracht, wobei als Substituenten für die Kupplungskomponenten im wesentlichen Hydroxy-, Alkoxy-, Alkyl-, Aryl-, Amino-, substituierte Amino-, Carboxyl-, Carbonamid-, Sulfonsäure-, Sulfonamid-, Sulfon- und Phosphonsäure-Gruppen sowie Halogenatome zu nennen sind; zu den bevorzugten Kupplungskomponenten, von denen sich der Rest $R^4$ ableitet, gehören die Kupplungskomponenten der Benzol-, z.B. Anilin-, und Naphthalin-Reihe.

In den erfindungsgemäß einzusetzenden Farbstoffen der allgemeinen Formel (I) bedeutet n eine ganze Zahl von 1 bis 6, insbesondere eine ganze Zahl von 1 bis 3, kann aber für den Fall, daß wenigstens einer der Reste R oder $R^1$ eine $-N=N\text{-}R^4$-Gruppe (mit $R^4$ gleich dem Rest einer, vorzugsweise wasserlöslichen, Kupplungskomponente) bedeutet, auch gleich 0 sein.

Für den erfindungsgemäßen Einsatz in den lichtempfindlichen Aufzeichnungselementen sind dabei solche Farbstoffe der allgemeinen Formel (I) besonders bevorzugt, bei denen in der Formel (I) X, M und n die vorstehend angegebenen Bedeutungen haben und die Reste R und $R^1$ gleich oder verschieden sind und einen der folgenden Reste bedeuten: eine $-NO_2$-Gruppe, eine $-NH_2$-Gruppe, eine $-N=N\text{-}R^4$-Gruppe (mit $R^4$ gleich dem Rest einer wasserlöslichen Kupplungskomponente der vorstehend genannten Art) oder eine $-NHCOR^2$-Gruppe, worin $R^2$ steht für ein Wasserstoffatom, eine $C_1$-$C_4$-Alkylgruppe, insbesondere Methyl oder Ethyl, für einen Phenylrest oder für einen durch eine oder zwei Methyl-, Methoxy- oder Hydroxy-Gruppen, durch eine Amino-Gruppe, durch eine -$COOR^8$-Gruppe (mit $R^8$ gleich einem Wasserstoffatom oder einem $C_1$-$C_4$-Alkylrest) oder durch eine -$SO_3M$-, -$PO_3HM$- oder -$PO_3M_2$-Gruppe (mit M gleich einer der weiter oben hierfür genannten Bedeutung) substituierten Phenylring. Unter den -$NHCOR^2$-Gruppen für die Reste R und $R^1$ in der allgemeinen Formel (I) sind dabei insbesondere diejenigen bevorzugt, in denen $R^2$ einen Methylrest, einen Ethylrest oder einen gegebenenfalls durch eine Methyl-, Amino- oder Sulfonsäure-Gruppe substituierten Phenylrest darstellt.

Ganz besonders bevorzugt als Farbstoffe für den erfindungsgemäßen Einsatz in den lichtempfindlichen Aufzeichnungselementen sind solche Verbindungen der allgemeinen Formel (I), bei denen X eine -N = N- oder eine -N(O) = N-Gruppe, M ein Wasserstoffatom bzw. Proton, ein Alkalimetall-Kation, das Ammonium-Kation oder ein Amin-Kation der weiter oben angeführten Art, R und $R^1$, die gleich oder verschieden sein können, eine -$NO_2$- oder eine -$NH_2$-Gruppe und n eine ganze Zahl von 1 bis 3 sind, darüber hinaus solche Farbstoffe der Formel (I), in denen R und $R^1$ für eine -N = N-$R^4$-Gruppe (mit $R^4$ = dem Rest einer wasserlöslichen Kupplungskomponente der Benzol- oder Naphthalinreihe) stehen und n = 0 ist.

Die Farbstoffe der allgemeinen Formel (I) sind als solche bekannt oder können nach bekannten Methoden hergestellt werden. Beispiele für diese Farbstoffe, die erfindungsgemäß in den lichtempfindlichen Aufzeichnungsmaterialien enthalten sind, sind u.a. in Venkataraman, Chemistry of Synthetic Dyes, Vol. 1 (1952) S. 628 ff. beschrieben. Andere erfindungsgemäß geeignete Farbstoffe sind z.B. aus der DE-A-24 05 855, der DE-A-30 07 077 und der EP-A-13 750 bekannt oder können nach den dort beschriebenen Verfahren hergestellt werden.

Beispiele für besonders bevorzugte erfindungsgemäß einzusetzende Farbstoffe sind solche Verbindungen der allgemeinen Formel (I), wie sie durch Selbstkondensation von 5-Nitro-o-toluolsulfonsäure, beispielsweise nach dem in der DE-C-16 44 308 beschriebenen Verfahren, hergestellt werden können. Zu den erfindungsgemäß besonders bevorzugten Farbstoffen gehören auch C.I.Direct Yellow 11 (C.I. 40000) sowie analoge und analog hergestellte Farbstoffe.

Beispiele für sehr vorteilhafte erfindungsgemäß einzusetzende Farbstoffe sind unter anderem auch die Verbindungen der nachfolgenden Formeln (II), (III) und (IV).

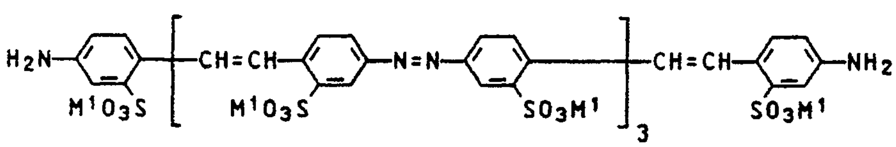 (II)

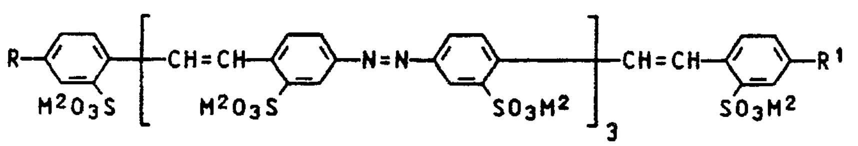 (III)

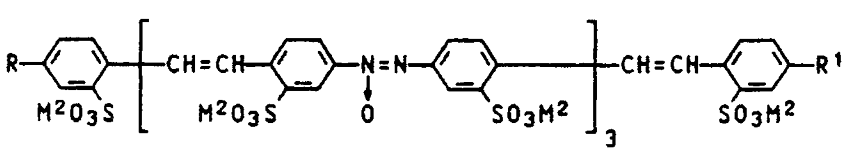 (IV)

In der Formel (II) steht $M^1$ dabei für das $H_2N^{\oplus}(CH_2CH_2OH)_2$-Kation. In den Formeln (III) und (IV) stehen $M^2$ für das $H_2N^{\oplus}(C_2H_5)_2$-Kation und die Reste R und $R^1$, unabhängig von einander, für eine -$NO_2$-Gruppe oder eine -$NH_2$-Gruppe.

Weitere Beispiele für Farbstoffe der allgemeinen Formel (I), die sich bei dem erfindungsgemäßen Einsatz in den lichtempfindlichen Aufzeichnungselementen als sehr günstig erwiesen haben, sind die Verbindungen der nachstehenden Formel (V)

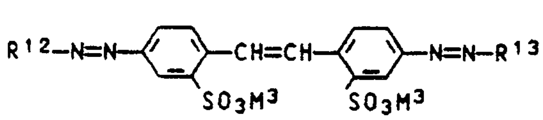 (V).

In der Formel (V) stehen $M^3$ für das Kalium-Kation und/oder das $HN^{\oplus}(CH_2CH_2OH)_3$-Kation und die Reste $R^{12}$ und $R^{13}$, unabhängig voneinander, für einen o-Kresotinsäure-Rest (1). H-Säure-Rest (2) oder γ-Säure-Rest (3).

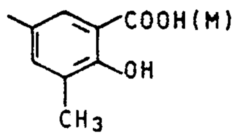
(1)

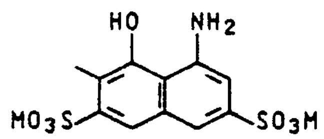
(2)

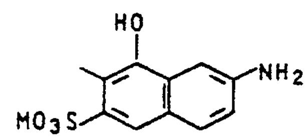
(3),

wobei in den Reste (1) bis (3) M die oben angegebene Bedeutung hat. Zur Herstellung der Farbstoffe der Formel (V) kann dabei nur eine einzige Kupplungskomponente oder auch ein Gemisch von zwei oder mehreren Kupplungskomponenten eingesetzt werden, wobei im letzteren Fall ein Gemisch von Farbstoffen resultiert.

Die Farbstoffe der allgemeinen Formel (I) sind in der lichtempfindlichen Aufzeichnungsschicht und/oder gegebenenfalls vorhandenen Zwischenschichten der erfindungsgemäßen lichtempfindlichen Aufzeichnungselemente in zur Einstellung der gewünschten Fotoeigenschaften wirksamen Mengen vorhanden, wie sie an sich bekannt und üblich sind bzw. durch einige wenige, einfache Versuche leicht ermittelt werden können. Die Konzentration der Farbstoffe in der bzw. den Schichten ist dabei unter anderem dem Verwendungszweck der lichtempfindlichen Aufzeichnungselemente (wie z.B. Einsatz im Hoch-, Flexo- oder Tiefdruck oder als Fotoresist), der Stärke der einzelnen Schichten, dem Aufbau der lichtempfindlichen Aufzeichnungselemente (ein- oder mehrlagige lichtempfindliche Aufzeichnungsschicht, Zwischenschichten etc.) und auch der Art und Intensität der bei der Verarbeitung verwendeten Lichtquelle anzupassen und kann demzufolge in weiten Grenzen variieren.

Zu dem Aufbau der erfindungsgemäßen lichtempfindlichen Aufzeichnungselemente ist im übrigen folgendes zu sagen:

Als Träger kommen die für lichtempfindliche Aufzeichnungselemente der in Rede stehenden Art üblichen und an sich bekannten, dimensionsstabilen, starren oder vorzugsweise flexiblen Schichtträger in Betracht, deren Auswahl vom Verwendungszweck der lichtempfindlichen Aufzeichnungselemente mitbestimmt wird. So werden für die Herstellung von Druck- oder Reliefformen als dimensionsstabile Träger insbesondere Kunststoff-Filme oder -Folien, insbesondere aus Polyestern, wie z.B. Polyethylenterephthalat, sowie auch metallische Schichtträger, beispielsweise Stahl- oder Aluminium-Bleche, eingesetzt. In diesen Fällen ist die lichtempfindliche Aufzeichnungsschicht haftfest auf dem dimensionsstabilen Träger aufgebracht. Hierzu können die Trägermaterialien gegebenenfalls in an sich bekannter Weise, z.B. mechanisch, chemisch, elektrochemisch und/oder durch Versehen mit einer Haftgrundierung, vorbehandelt sein. Für Fotoresistfilme und Schichtübertragungsmaterialien finden als Trägermaterialien vorzugsweise Kunststoff-Filme oder -Folien, insbesondere Polyester-Folien, z.B. aus Polyethylenterephthalat, Verwendung, die eine mäßige Haftung zu der lichtempfindlichen Aufzeichnungsschicht haben und nach dem Auflaminieren bzw. Aufkaschieren der lichtempfindlichen Aufzeichnungsschicht auf ein Substrat von dieser - vor oder nach der Belichtung mit aktinischem Licht - abgezogen werden können. Für die Herstellung von Resistmustern kann die lichtempfindliche Aufzeichnungsschicht auch direkt auf das zu schützende sowie gegebenenfalls dauerhaft zu modifizierende Substrat aufgebracht werden, welches dann als Träger für die lichtempfindliche Aufzeichnungsschicht fungiert. Als Substrate für lichtempfindliche Resistschichten kommen beispielsweise Kupferbleche, kupferkaschierte Basismaterialien, Keramiksubstrate, die mit metallischen oder metalloxidischen Schichten beschichtet sind, Halbleiterelemente, Silicium-Wafer und dergleichen in Betracht.

Die lichtempfindliche Aufzeichnungsschicht der erfindungsgemäßen lichtempfindlichen Aufzeichnungselemente kann positiv oder negativ arbeitend sein und grundsätzlich aus beliebigen, für solche Schichten an sich bekannten Materialien gebildet werden. Beispielsweise kommen für die lichtempfindliche Aufzeichnungsschicht die bekannten fotoabbaubaren Materialien bzw. solche Materialien, die bei Bestrahlung mit aktinischem Licht in Lösungsmitteln löslich werden, in denen sie zuvor unlöslich waren, in Betracht. Hierzu gehören beispielsweise die positiv arbeitenden Aufzeichnungsmaterialien auf Basis von o-Chinondiazid-Gruppen enthaltenden Verbindungen, wie sie u.a. in der DE-A-20 28 903, der DE-A-22 36 914, der US-A-3 782 939, der US-A-3 837 860 und der US-A-4 193 797 beschrieben sind. Hierzu gehören insbesondere auch die lichtempfindlichen Aufzeichnungsmaterialien, welche als lichtempfindliche Komponente eine Verbindung mit mindestens zwei aromatischen und/oder heteroaromatischen o-Nitrocarbinolester-Gruppierungen enthalten, wie sie beispielsweise in der DE-C-21 50 691, der DE-B-23 09 062, der DE-A-29 22 746, der

US-A-4 456 679, der US-A-4 465 760, der EP-A-101 586 oder der EP-A-141 389 beschrieben sind.

Vorzugsweise wird die lichtempfindliche Aufzeichnungsschicht der erfindungsgemäßen lichtempfindlichen Aufzeichnungselemente aus einem fotopolymerisierbaren Gemisch gebildet, welches neben mindestens einem Fotopolymerisationsinitiator mindestens eine ethylenisch ungesättigte, fotopolymerisierbare Verbindung enthält, wobei es sich bei der ethylenisch ungesättigten, fotopolymerisierbaren Verbindung sowohl um Monomere, Oligomere oder fotopolymerisierbare bzw. fotovernetzbare Gruppen enthaltende Polymere handeln kann und wobei in dem fotopolymerisierbaren Gemisch vorzugsweise nur solche ethylenisch ungesättigten, fotopolymerisierbaren Verbindungen enthalten sind, die zwei oder mehr ethylenisch ungesättigte, fotopolymerisierbare Doppelbindungen aufweisen, oder deren Mischungen mit ethylenisch ungesättigten, fotopolymerisierbaren Verbindungen mit nur einer ethylenisch ungesättigten, fotopolymerisierbaren Doppelbindung. Die fotopolymerisierbaren Gemische können darüber hinaus auch noch weitere Bestandteile enthalten, wie insbesondere polymere Bindemittel, die mit den ethylenisch ungesättigten, fotopolymerisierbaren Verbindungen verträglich sind, thermische Polymerisationsinhibitoren, Füllstoffe, Weichmacher, sensitometrische Regler, fotochrome Verbindungen bzw. Systeme und dergleichen. Solche fotopolymerisierbaren Gemische für lichtempfindliche Aufzeichnungsschichten sind dem Fachmann hinreichend bekannt und in der einschlägigen Fachliteratur beschrieben.

Insbesondere vorteilhaft sind hierbei die mit wäßrigen Entwicklerlösungen entwickelbaren, lichtempfindlichen fotopolymerisierbaren Aufzeichnungsschichten, d.h. die lichtempfindlichen Aufzeichnungsschichten, die aus einem fotopolymerisierbaren Gemisch gebildet werden, welches in den wäßrigen Entwicklerlösungen löslich oder zumindest dispergierbar ist. Diese fotopolymerisierbaren Gemische enthalten mindestens ein gesättigtes und/oder ungesättigtes, fotopolymerisierbares bzw. fotovernetzbares polymeres Bindemittel, mindestens eine ethylenisch ungesättigte, fotopolymerisierbare niedermolekulare Verbindung, mindestens einen Fotopolymerisationsinitiator sowie gegebenenfalls weitere Zusatz-und/oder Hilfsstoffe, wie z.B. thermische Polymerisationsinhibitoren, Weichmacher, Verlaufshilfsmittel, Füllstoffe und dergleichen. Als Beispiel hierfür seien die mit Wasser/Alkohol-Entwicklerlösungen auswaschbaren fotopolymerisierbaren Gemische genannt, die als Bindemittel mindestens ein lösliches Polyamid oder Copolyamid, mindestens eine damit verträgliche, ethylenisch ungesättigte niedermolekulare Verbindung mit mindestens zwei fotopolymerisierbaren Doppelbindungen, mindestens einen Fotoinitiator sowie gegebenenfalls weitere Zusatz-und/oder Hilfsstoffe der genannten Art enthalten, wie sie z.B. in der FR-A-15 20 856 oder der DE-A-22 02 357 beschrieben sind.

Von besonderem Vorteil sind die lichtempfindlichen Aufzeichnungselemente mit einer wasserentwickelbaren lichtempfindlichen Aufzeichnungsschicht aus einem fotopolymerisierbaren Gemisch auf Basis von wasserlöslichen oder zumindest wasserdispergierbaren polymeren Bindemitteln, wie sie beispielsweise in den britischen Patentschriften 834 337, 1 233 883, 1 351 475, 786 119, 814 227, 835 849, den US-Patentschriften 3 801 328, 3 877 939 und 4 272 611, der DE-A-31 44 905, der EP-A-70 510, der EP-A-70 511 oder der EP-A-129 901 beschrieben sind. Als Beispiele für Polymere, die in diesen fotopolymerisierbaren Gemischen enthalten sein können, seien die bekannten, in Wasser löslichen oder zumindest dispergierbaren Homo- oder Copolymerisate des N-Vinylpyrrolidons genannt, wobei als Comonomeren beispielsweise Vinylester, z.B. Vinylacetat, erwähnt seien. Auch verseifte N-Vinylpyrrolidon-Vinylester-Copolymerisate sind geeignet. Als vorteilhafte Bindemittel für diese fotopolymerisierbaren Gemische haben sich insbesondere Vinylalkohol-Polymerisate mit $-CH_2CH(OH)$-Struktureinheiten in der Polymerhauptkette erwiesen sowie deren in Wasser oder wäßrigen Lösungsmitteln lösliche oder dispergierbare Copolymerisate und Derivate, wie Ester, Ether oder Acetale. Besonders geeignet sind die bekannten teilverseiften Polyvinylester von aliphatischen Monocarbonsäuren mit 1 bis 4 C-Atomen, wie Polyvinylacetate oder Polyvinylproprionate, deren mittlerer Polymerisationsgrad im Bereich von etwa 200 bis 3000 liegt und deren Verseifungsgrad 65 bis 99 Mol%, insbesondere etwa 80 bis 88 Mol%, beträgt. Auch Gemische von verseiften Vinylester-Polymerisaten oder -Copolymerisaten mit unterschiedlichem Polymerisationsgrad und/oder unterschiedlichem Verseifungsgrad können eingesetzt werden. Ferner seien als Polymere in diesem Zusammenhang auch die Umsetzungsprodukte von Vinylalkohol-Polymerisaten mit Acryl- und/oder Methacrylsäureanhydrid erwähnt, wobei diese Umsetzungsprodukte im allgemeinen 1 bis 12 Mol%, bezogen auf das Umsetzungsprodukt, an Acryloyl-und/oder Methacryloyl-Gruppen eingebaut enthalten, als auch die wasserlöslichen Umsetzungsprodukte von Vinylalkohol-Polymerisaten mit Ethylenoxid, wobei der Anteil der Ethylenoxid-Einheiten in dem oxethylierten Vinylalkohol-Polymerisat 5 bis 75 Gew.-%, insbesondere 10 bis 60 Gew.-%, betragen kann. Diese Umsetzungsprodukte von Vinylalkohol-Polymerisaten können als alleinige Polymer-Komponente in den fotopolymerisierbaren Gemischen enthalten sein, sie können aber auch in Mischung mit anderen verträglichen Polymeren, insbesondere den vorstehend erwähnten teilverseiften Polyvinylestern, vorliegen.

Sofern die fotopolymerisierbaren Gemische Polymere mit ethylenisch ungesättigten fotopolymerisierbaren bzw. fotovernetzbaren Gruppen enthalten, ist der Zusatz von fotopolymerisierbaren, ethylenisch ungesättigten niedermolekularen Verbindungen zu den fotopolymerisierbaren Gemischen nicht unbedingt notwendig, jedoch häufig vorteilhaft.

Als Beispiel für die fotopolymerisierbaren, ethylenisch ungesättigten niedermolekularen Verbindungen seien insbesondere die Acryloyl-und/oder Methacryloyl-Gruppen enthaltenden niedermolekularen Verbindungen genannt, wozu u.a. gehören: Mono-, Di- und Poly(meth)acrylate, wie sie durch Veresterung von Acrylsäure oder Methacrylsäure mit ein- oder mehrwertigen niedermolekularen Alkoholen erhalten werden, wie z.B. die Di-und Tri-(meth)acrylate von Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, 2,2-Dimethylpropandiol, 1,4-Butandiol, 1,1,1-Trimethylolpropan, Glycerin oder Pentaerythrit; ferner die Monoacrylate und Monomethacrylate solcher Diole oder Polyole, wie z.B. Ethylenglykol-mono-(meth)acrylat, Propandiol-mono-(meth)acrylat und Di-, Tri- oder Tetraethylenglykol-mono-(meth)acrylat; die (Meth)acrylate von Monoalkanolen mit 1 bis 8 C-Atomen, (Meth)acrylamid und Mono- und Bis-(meth)acrylamide von aliphatischen oder aromatischen Diaminen mit 2 bis 8 C-Atomen, Derivate der (Meth)acrylamide, z.B. Hydroxymethyl-(meth)acrylamid oder insbesondere das Umsetzungsprodukt von 2 Mol N-Hydroxymethyl-(meth)acrylamid mit einem Mol eines aliphatischen Diols, z.B. Ethylenglykol oder Propylenglykol; ferner niedermolekulare, urethangruppenhaltige Acrylat- oder Methacrylat-Verbindungen.

Die Auswahl der fotopolymerisierbaren, ethylenisch ungesättigten Verbindungen richtet sich in bekannter Weise nach den in den fotopolymerisierbaren Gemischen enthaltenen Polymeren und dem gewünschten Verwendungszweck der lichtempfindlichen Aufzeichnungselemente. Sie ist dem Fachmann geläufig und u.a. aus den vorstehend zitierten Druckschriften zu entnehmen. Die fotopolymerisierbaren Gemische enthalten die Polymeren und die fotopolymerisierbaren, ethylenisch ungesättigten niedermolekularen Verbindungen im allgemeinen in einer Menge von etwa 40 bis 90 Gew.-% bzw. von 10 bis 60 Gew.-%, jeweils bezogen auf die Summe von Polymeren und fotopolymerisierbarer, ethylenisch ungesättigter niedermolekularer Verbindung. Der Anteil der fotopolymerisierbaren, ethylenisch ungesättigten niedermolekularen Verbindungen kann in einzelnen Fällen auch größer oder kleiner sein. So ist es beispielsweise möglich, den Anteil der fotopolymerisierbaren, ethylenisch ungesättigten niedermolekularen Verbindungen unter 10 Gew.-% abzusenken, wenn in der fotopolymerisierbaren Mischung ungesättigte Polymere mit einem hinreichend hohen Gehalt an fotopolymerisierbaren bzw. fotovernetzbaren Doppelbindungen enthalten sind; er kann auch über 60 Gew.-% betragen, beispielsweise wenn fotopolymerisierbare Oligomere mitverwendet werden, solange die lichtempfindliche Aufzeichnungsschicht bei Raumtemperatur fest ist.

Als Fotopolymerisationsinitiatoren, die in dem fotopolymerisierbaren Gemisch im allgemeinen in einer Menge von 0,05 bis 10 Gew.-%, insbesondere von 0,5 bis 5 Gew.-%, bezogen auf die fotopolymerisierbare Mischung, enthalten sind, kommen die bekannten und üblichen Fotopolymerisationsinitiatoren in Betracht. Beispielhaft hierfür seien genannt: Benzoin, Benzoinether, insbesondere Benzoinalkylether, substituierte Benzoine, Alkylether von substituierten Benzoinen, wie z.B. $\alpha$-Methylbenzoinalkylether oder $\alpha$-Hydroxymethylbenzoinalkylether; Benzil, Benzilketale, wie insbesondere Benzildimethylketal; die als Fotoinitiator bekannten und wirksamen Acylphosphinoxid-Verbindungen, wie z.B. 2,4,6-Trimethylbenzoyldiphenylphosphinoxid; Benzophenon, Derivate des Benzophenons, Michlers Keton, Derivate von Michlers Keton; Anthrachinon und substituierte Anthrachinone, arylsubstituierte Imidazole oder deren Derivate, wie z.B. 2,4,5-Triarylimidazoldimere und dergleichen. Darüber hinaus können die fotopolymerisierbaren Gemische für die lichtempfindlichen Aufzeichnungsschichten die vorstehend genannten üblichen und an sich bekannten Zusatz- und/oder Hilfsstoffe in den hierfür üblichen und bekannten, wirksamen Mengen enthalten. Insbesondere sind die Komponenten nach Art und Menge so aufeinander abgestimmt, daß die lichtempfindliche Aufzeichnungsschicht der erfindungsgemäßen lichtempfindlichen Aufzeichnungselemente bei Raumtemperatur fest ist.

Die erfindungsgemäßen lichtempfindlichen Aufzeichnungselemente können, insbesondere wenn sie zur Herstellung von Druck- oder Reliefformen dienen, zwischen dem dimensionsstabilen Träger und der lichtempfindlichen Aufzeichnungsschicht auch noch mindestens eine Zwischenschicht enthalten, die insbesondere als Haftschicht und/oder Lichthofschutzschicht ausgebildet ist. Bei diesen Zwischenschichten handelt es sich im allgemeinen um polymere Schichten, die lichtempfindlich oder auch nicht-lichtempfindlich sein können. Haftschichten enthalten im allgemeinen ein Polymeres, welches dem polymeren Bindemittel in der lichtempfindlichen Aufzeichnungsschicht entspricht oder diesem zumindest ähnlich ist. Als haftvermittelnde Zwischenschichten kommen beispielsweise solche auf Basis von Polyurethanen, Polyvinylalkoholen oder Polyvinylalkohol-Derivaten, Polyamiden, Epoxidharzen, Melamin-Formaldehyd-Harzen und ähnlichen in Betracht, wie sie u.a. in der DE-A-15 97 515, der US-A-3 877 939, der EP-A-53 258, der EP-A-53 260, der EP-A-2 321, der US-A-4 387 157, der US-A-4 355 093 oder US-A-4 357 414 beschrieben sind. Diese Zwischenschichten können dabei auch polymerisierbare Monomere, wie beispielsweise Hydroxyalkyl-

(meth)acrylate oder Urethan(meth)acrylate, sowie auch einen Fotoinitiator enthalten. Wenn die Zwischenschichten als Lichthofschutzschicht ausgebildet sind, um bei der bildmäßigen Belichtung der lichtempfindlichen Aufzeichnungsschicht eine übermäßig hohe und unerwünschte Reflexion des eingestrahlten Lichtes durch den dimensionsstabilen Träger zu vermeiden, enthalten diese Zwischenschichten Farbstoffe und/oder Pigmente, die Licht in dem aktinischen Wellenlängenbereich absorbieren.

Da die erfindungsgemäß in den lichtempfindlichen Aufzeichnungselementen enthaltenen Farbstoffe nicht oder zumindest praktisch nicht migrieren und sich damit auch die Fotoeigenschaften der diese Farbstoffe enthaltenden lichtempfindlichen Aufzeichnungselemente selbst bei langer Lagerung nicht ändern, ist es erfindungsgemäß möglich und zur Steuerung der Belichtungseigenschaften der lichtempfindlichen Aufzeichnungselemente bzw. der fotochemischen Prozesse hierin auch besonders vorteilhaft, wenn die in der lichtempfindlichen Aufzeichnungsschicht und/oder den gegebenenfalls vorhandenen Zwischenschichten erfindungsgemäß enthaltenen Farbstoffe, über die Dicke des Aufzeichnungselementes hinweg gesehen, d.h. von der äußeren Oberfläche der lichtempfindlichen Aufzeichnungsschicht in Richtung Träger, in abgestufter Konzentration enthalten sind. Da die Steuerung der fotochemischen Eigenschaften der lichtempfindlichen Aufzeichnungselemente nach verschiedenen Prinzipien erfolgen kann, können dementsprechend auch die erfindungsgemäß in den lichtempfindlichen Aufzeichnungselementen enthaltenen Farbstoffe in verschiedener Art in der lichtempfindlichen Aufzeichnungsschicht und/oder gegebenenfalls vorhandenen Zwischenschichten enthalten sein.

So kann es beispielsweise zum einen erwünscht sein, bei der bildmäßigen Belichtung der lichtempfindlichen Aufzeichnungselemente die Intensität des von oben in die lichtempfindliche Aufzeichnungsschicht eingestrahlten aktinischen Lichtes in verschiedenen Schichttiefen in bestimmter Weise zu drosseln und so die durch das Licht angeregten Vorgänge je nach Eindringtiefe unterschiedlich abzuschwächen. Hierdurch werden beispielsweise Gestalt und Druckeigenschaften einer Hochdruck-oder Tiefdruckform deutlich beeinflußt. Zur Erreichung dieses Ziels können die erfindungsgemäß einzusetzenden Farbstoffe in der lichtempfindlichen Aufzeichnungsschicht in über die Schichtdicke der Aufzeichnungsschicht hinweg abgestufter Konzentration enthalten sein. Dies kann beispielsweise dadurch erzielt werden, daß die lichtempfindliche Aufzeichnungsschicht aus zwei oder mehr Lagen aufgebaut ist, die den oder die Farbstoffe in unterschiedlichen Konzentrationen enthalten. Dabei kann in einer oder mehreren dieser Lagen der lichtempfindlichen Aufzeichnungsschicht die Farbstoffkonzentration auch gleich 0 sein, d.h. einzelne Lagen einer mehrlagigen lichtempfindlichen Aufzeichnungsschicht brauchen keinen Farbstoff zu enthalten, wenn zumindest in einer Lage der mehrlagigen lichtempfindlichen Aufzeichnungsschicht ein erfindungsgemäß einzusetzender Farbstoff vorhanden ist. Dabei nimmt im allgemeinen die Farbstoffkonzentration in den einzelnen Lagen der mehrlagigen lichtempfindlichen Aufzeichnungsschichten entweder von der äußeren Oberfläche der lichtempfindlichen Aufzeichnungsschicht zum dimensionsstabilen Träger hin zu oder umgekehrt auch ab. Das gleiche Prinzip kann auch mit einer einlagigen lichtempfindlichen Aufzeichnungsschicht realisiert werden, wenn in dieser lichtempfindlichen Aufzeichnungsschicht die erfindungsgemäß einzusetzenden Farbstoffe mit einem von der äußeren Oberfläche der lichtempfindlichen Aufzeichnungsschicht zum dimensionsstabilen Träger hin verlaufenden Konzentrationsgradienten enthalten sind.

In anderen Fällen soll bei der bildmäßigen Belichtung der lichtempfindlichen Aufzeichnungselemente das in die lichtempfindliche Aufzeichnungsschicht eindringende aktinische Licht beim Durchgang durch die lichtempfindliche Aufzeichnungsschicht möglichst wenig geschwächt werden. Gleichzeitig soll aber auch vermieden werden, insbesondere bei Einsatz von nicht-transparenten dimensionsstabilen Trägern oder lichtstreuenden, z.B. Pigmente enthaltenden Zwischenschichten, daß das bildmäßig eingestrahlte aktinische Licht durch Reflexion und/oder Streuung am Träger oder in einer Zwischenschicht in Bereiche der lichtempfindlichen Aufzeichnungsschicht zurückgeworfen wird, die unbelichtet bleiben sollen. Bei der Herstellung von Hochdruckformen machen sich Reflexion und Streuung in einer zu geringen Ausbildung der sogenannten Zwischentiefen bemerkbar, wodurch vielfach der Druckprozeß erheblich beeinträchtigt wird. In diesen Fällen enthält die lichtempfindliche Aufzeichnungsschicht keinen Farbstoff oder nur Farbstoffe in geringer Konzentration, die dann vorzugsweise gleichmäßig in der lichtempfindlichen Aufzeichnungsschicht enthalten sind, und es sind die erfindungsgemäß einzusetzenden Farbstoffe im Sockelbereich der lichtempfindlichen Aufzeichnungsschicht angeordnet. Dies erfolgt meist und am einfachsten dadurch, daß die erfindungsgemäß einzusetzenden Farbstoffe in diesem Fall in einer Zwischenschicht zwischen dimensionsstabilem Träger und lichtempfindlicher Aufzeichnungsschicht eingearbeitet sind, die vorzugsweise unmittelbar benachbart zu der lichtempfindlichen Aufzeichnungsschicht angeordnet ist.

Selbstverständlich ist es auch möglich, daß die erfindungsgemäß in den lichtempfindlichen Aufzeichnungselementen enthaltenen Farbstoffe sowohl in der lichtempfindlichen Aufzeichnungsschicht als auch einer oder mehreren vorhandenen Zwischenschichten enthalten sind, und zwar insbesondere in unterschiedlicher Konzentration in den einzelnen Schichten, wobei die Konzentration der Farbstoffe in der oder den

Zwischenschichten in aller Regel höher sein wird als die in der lichtempfindlichen Aufzeichnungsschicht. In diesem Fall kann der Farbstoff in der lichtempfindlichen Aufzeichnungsschicht sowohl homogen verteilt sein als auch in über die Schichtdicke hinweg abgestufter Konzentration vorliegen. Bei lichtempfindlichen Aufzeichnungselementen, die mehrere Zwischenschichten zwischen dimensionsstabilem Träger und lichtempfindlicher Aufzeichnungsschicht aufweisen, ist es möglich, daß die erfindungsgemäß einzusetzenden Farbstoffe in nur einer, mehreren oder auch allen dieser Zwischenschichten enthalten sind. Als vorteilhaft, aber keineswegs zwingend, hat es sich dabei erwiesen, wenn die erfindungsgemäß einzusetzenden Farbstoffe in der der lichtempfindlichen Aufzeichnungsschicht unmittelbar benachbarten, d.h. an diese angrenzenden, Zwischenschicht enthalten sind. Darüber hinaus sind natürlich mit den erfindungsgemäß einzusetzenden Farbstoffen die verschiedensten Variationen der vorstehend beschriebenen Einfärbungen der lichtempfindlichen Aufzeichnungselemente möglich, ebenso wie auch andere Prinzipien inhomogener oder diskontinuierlicher Einfärbung der lichtempfindlichen Aufzeichnungsschicht und/oder der gegebenenfalls vorhandenen Zwischenschichten.

Die erfindungsgemäßen lichtempfindlichen Aufzeichnungselemente können ferner auf der äußeren, d.h. dem dimensionsstabilen Träger abgewandten Oberfläche der lichtempfindlichen Aufzeichnungsschicht auch noch eine Deckschicht, die vorzugsweise in dem gleichen Entwicklerlösungsmittel löslich ist wie die lichtempfindliche Aufzeichnungsschicht, und/oder eine Deckfolie, die von der lichtempfindlichen Aufzeichnungsschicht bzw. einer gegebenenfalls vorhandenen Deckschicht abziehbar ist, enthalten. Solche Deckschichten bzw. Deckfolien dienen vor allem dem Schutz der lichtempfindlichen Aufzeichnungsschicht bei der Lagerung und Handhabung der lichtempfindlichen Aufzeichnungselemente sowie gegebenenfalls als Sauerstoffsperre, insbesondere wenn die lichtempfindliche Aufzeichnungsschicht aus einem fotopolymerisierbaren Gemisch gebildet wird. Als besonders geeignet haben sich z.B. Deckschichten bzw. -folien aus Polyvinylalkoholen oder Polyvinylalkohol-Derivaten, Polyolefinen, Polyestern oder dergleichen erwiesen.

Die Herstellung der erfindungsgemäßen lichtempfindlichen Aufzeichnungselemente kann in an sich üblicher und bekannter Weise erfolgen. Beispielsweise kann eine homogene Mischung der die lichtempfindliche Aufzeichnungsschicht bildenden Komponenten hergestellt und diese schichtförmig auf den - gegebenenfalls mit einer oder mehreren Zwischenschichten versehenen - dimensionsstabilen Träger aufgebracht werden. Das Mischen der Komponenten der lichtempfindlichen Aufzeichnungsschicht kann in einer geeigneten Mischvorrichtung, z.B. einem Mischer oder Extruder, oder auch in Lösung in einem geeigneten Lösungsmittel oder Lösungsmittelgemisch erfolgen. Das Beschichten des - gegebenenfalls mit der oder den Zwischenschichten versehenen - dimensionsstabilen Trägers mit dem lichtempfindlichen Aufzeichnungsmaterial kann beispielsweise durch Auflaminieren oder Aufkaschieren einer vorgefertigten Schicht aus dem lichtempfindlichen Aufzeichnungsmaterial oder auch aus Lösung durch Gießen, Tauchen, Sprühen oder andere bekannte Auftragstechniken und anschließendes Abdampfen des Lösungsmittels erfolgen. Bei mehrlagigen lichtempfindlichen Aufzeichnungsschichten können die einzelnen Lagen entweder nacheinander durch Auftrag aus Lösung übereinander angeordnet werden, es ist aber auch möglich, die einzelnen Lagen der lichtempfindlichen Aufzeichnungsschicht vorzufertigen und dann anschließend in der gewünschten Reihenfolge, beispielsweise durch Kaschieren oder Laminieren, miteinander zu verbinden. Bei lichtempfindlichen Aufzeichnungselementen, die zwischen Träger und lichtempfindlicher Aufzeichnungsschicht eine oder mehrere Zwischenschichten enthalten, können diese Zwischenschichten ebenfalls in an sich bekannter Weise, beispielsweise durch Auftrag aus Lösung, durch Laminieren oder Kaschieren auf dem Träger aufgebracht werden. Die erfindungsgemäß in den lichtempfindlichen Aufzeichnungselementen enthaltenen Farbstoffe werden bei der Herstellung in den gewünschten Konzentrationen in die Materialien für die einzelnen Schichten bzw. - bei mehrlagigen Aufzeichnungsschichten - für die einzelnen Lagen der Aufzeichnungsschicht eingearbeitet. Die Herstellung eines lichtempfindlichen Aufzeichnungselements mit einem Konzentrationsgradienten des Farbstoffs in einer einlagigen lichtempfindlichen Aufzeichnungsschicht kann beispielsweise erfolgen, indem man den Farbstoff aus einer einseitig aufgebrachten Lösung in die frisch aus Lösung gegossene, noch stark lösungsmittelhaltige lichtemfpindliche Aufzeichnungsschicht, gegebenenfalls bei erhöhter Temperatur, eindiffundieren läßt. Auch durch Verwendung einer Mehrschichtengießvorrichtung, mittels der in einem Arbeitsgang zwei oder mehrere lichtempfindliche Schichten mit unterschiedlicher Farbstoffkonzentration, sonst aber gleicher Zusammensetzung gegossen werden, läßt sich, bevor das Lösungsmittel im anschließenden Trockenvorgang entfernt wird, durch Diffussion ein Konzentrationsgradient des Farbstoffs aufbauen. Dieser Vorgang kann noch unterstützt werden durch bewußt erzeugte, partielle Vermischung benachbarter Schichten im Bereich der Grenzzonen. Letzteres ist selbstverständlich auch bei Coextrusion von zwei oder mehreren Schichten mit unterschiedlicher Farbstoffkonzentration möglich. Eine gegebenenfalls vorhandene Deckschicht und/oder Deckfolie kann nachträglich auf die lichtempfindliche Aufzeichnungsschicht aufgebracht werden, es ist jedoch auch möglich, zunächst die lichtempfindliche Aufzeichnungsschicht auf der Deckfolie oder Deckschicht, beispielsweise durch

Auftrag aus Lösung, herzustellen und dann den so vorgefertigten Verbund aus Deckschicht bzw. -folie und lichtempfindlicher Aufzeichnungsschicht mit dem Träger, der gegebenenfalls zuvor mit der oder den Zwischenschichten versehen worden ist, zu verbinden.

Die erfindungsgemäßen lichtempfindlichen Aufzeichnungselemente eignen sich beispielsweise zur Herstellung von bildmäßig strukturierten Resistschichten und Resistmustern sowie insbesondere zur Herstellung von Druck- und Reliefformen. Die erfindungsgemäßen lichtempfindlichen Aufzeichnungselemente lassen sich in bekannter Weise zu Druckklischees verarbeiten, indem sie nach einer eventuellen Vorbelichtung durch eine geeignete Bildvorlage bildmäßig mit aktinischem Licht belichtet und anschließend, beispielsweise durch Auswaschen mit einem geeigneten Entwicklerlösungsmittel, entwickelt werden. Anschließend können die so hergestellten Druck- oder Reliefformen bzw. Resistmuster noch einer Nachbehandlung unterzogen werden, wozu insbesondere die Trocknung und/oder eine nicht-bildmäßige Nachbelichtung gehören. Zur Vorbelichtung, Bildbelichtung und Nachbelichtung eignen sich die üblichen, aktinische Strahlung, insbesondere im Wellenlängenbereich von etwa 300 bis 400 nm, emittierenden Lichtquellen, wie UV-Fluoreszenzröhren, Quecksilberhoch-, -mittel- oder -niederdruckstrahler, superaktinische Leuchtstoffröhren, Xenon-Impulslampen, UV-Laser und ähnliche. Die erfindungsgemäßen lichtempfindlichen Aufzeichnungselemente zeichnen sich durch ihre guten und vorteilhaften Fotoeigenschaften aus, die auch bei langer Lagerung nicht verändert oder beeinträchtigt werden. Mit den erfindungsgemäßen lichtempfindlichen Aufzeichnungselementen können bildmäßige Vorlagen exakt und vorlagengetreu reproduziert werden, wobei die Belichtungseigenschaften und Strukturen der erhaltenen Reliefs einfach und in gewünschter Weise eingestellt werden können.

Die Erfindung wird durch die nachfolgenden Beispiele näher erläutert. Die in den Beispielen genannten Teile und Prozente beziehen sich, sofern nicht anders angegeben, auf das Gewicht.

Beispiele 1 bis 6 und Vergleichsversuche A und B

Auf Aluminiumbleche wurden aus Lösung Mischungen aus 98,5% eines teilverseiften Polyvinylacetats (Verseifungsgrad 82 Mol%; Molekulargewicht ca. 25000) und 1,5 % des jeweiligen, in der nachfolgenden Tabelle 1 angegebenen Farbstoffs schichtförmig so aufgetragen, daß nach dem Trocknen bei 100 bis 150 °C eine 10 µm starke Lichthofschutzschicht resultierte. Bei den in den Beispielen 4 bis 6 eingesetzten Farbstoffen handelt es sich um Farbstoffe der Formel (V).

Zur Herstellung einer fotopolymerisierbaren, lichtempfindlichen Aufzeichnungsschicht wurden zu einer Lösung von 222 Teilen eines teilverseiften Polyvinylacetats (Verseifungsgrad 83 Mol%; $M_w$: ca. 30000) und 95 Teilen eines teilverseiften Polyvinylacetats, das 22 % Polyoxyethylensegmente gebunden enthielt ($M_w$: 25000 bis 30000) in 318 Teilen Wasser eine Lösung von 48 Teilen Butandiol-1,4-dimethacrylat, 3,8 Teilen 2,4,6-Trimethylbenzoyl-diphenylphosphinoxid und 1,0 Teilen 2,6-Di-t.-butyl-p-kresol in 281 Teilen 2-Hydroxyethylmethacrylat zugesetzt. Die so erhaltene Lösung wurde filtriert und entgast und dann zu einer lichtempfindlichen, fotopolymerisierbaren Schicht gegossen, die nach dem Trocknen ca. 500 µm stark war.

Die so hergestellte lichtempfindliche, fotopolymerisierbare Schicht wurde unter einem Druck von 1 $N/cm^2$ auf die auf den Aluminiumblechen befindlichen Lichthofschutzschichten aufkaschiert. Die so erhaltenen lichtempfindlichen Aufzeichnungselemente wurden bei Raumtemperatur gelagert, wobei nach 7 bzw. 250 Tagen Lagerung das Eindiffundieren der verschiedenen Farbstoffe in die lichtempfindlichen, fotopolymerisierbaren Schichten visuell begutachtet wurden. Die Ergebnisse sind ebenfalls in der Tabelle 1 wiedergegeben. Wie sich hieraus ersehen läßt, war bei den erfindungsgemäß einzusetzenden Farbstoffen keine bzw. praktisch keine Migration erkennbar, wohingegen andere Sulfogruppen enthaltende Farbstoffe, wie sie im Stand der Technik für lichtempfindliche Aufzeichnungselemente empfohlen werden, bereits nach kurzer Lagerung in starkem Ausmaß in die fotopolymerisierbare, lichtempfindliche Aufzeichnungsschicht gewandert sind.

Tabelle 1

| Beispiel/ Vergleichsversuch | Farbstoff | Migration in die fotopolymerisierbare Aufzeichnungsschicht nach 7 Tagen | 250 Tagen |
|---|---|---|---|
| 1 | Farbstoff der Formel (II) | praktisch keine | praktisch keine |
| 2 | Farbstoff der Formel (III) | praktisch keine | praktisch keine |
| 3 | Direct Yellow 11 (C.I. 40 000) | äußerst gering | äußerst gering |
| 4 | Dye 5783 A | äußerst gering | äußerst gering |
| 5 | Dye 5783 B | keine | keine |
| 6 | Dye 5783 C | praktisch keine | praktisch keine |
| A | C.I.Acid Black 1 (C.I. 20 470) | sehr stark | |
| B | C.I.Acid Violet 19 (C.I. 42 685) | sehr stark | |

Beispiel 7

Aus 67,5 Teilen eines Polyvinylpyrrolidons mit einem mittleren Molekulargewicht (Gewichtsmittel) im Bereich von 600 000 bis 800 000 (K-Wert 92), 30 Teilen des Diethers aus 1 Mol Ethylenglykol und 2 Molen N-Hydroxymethylacrylamid, 0,1 Teilen N-Nitrosocyclohexylhydroxylamin und 2,5 Teilen α-Methylolbenzoinmethylether wurde eine 71%ige wäßrige Lösung hergestellt. Diese Lösung wurde zu einer lichtempfindlichen, fotopolymerisierbaren Schicht vergossen, die nach dem Trocknen bei erhöhter Temperatur eine Schichtdicke von 500 µm aufwies. Diese lichtempfindliche, fotopolymerisierbare Schicht wurde sodann auf ein mit einer 10 µm starken Haftschicht versehenes, alodiniertes Aluminiumblech aufkaschiert. Die Haftschicht war gebildet worden durch Auftrag einer wäßrig-methanolischen Lösung des gleichen Polymeren, wie es für die Herstellung der lichtempfindlichen, fotopolymerisierbaren Aufzeichnungsschicht eingesetzt worden war, unter Zusatz des Farbstoffs der allgemeinen Formel (II), Abdampfen des Lösungsmittels und Einbrennen der Schicht bei erhöhten Temperaturen. Die Menge an Farbstoff war so gewählt, daß er in der eingebrannten Haftschicht in einer Menge von 2 % enthalten war.

Mit dem so hergestellten lichtempfindlichen Aufzeichnungselement wurden durch bildmäßiges Belichten mit aktinischem Licht und Auswaschen der unbelichteten Bereiche der lichtempfindlichen Aufzeichnungsschicht mit Wasser Druckreliefs erhalten, deren nicht druckende Bereiche eine ausreichende Tiefe besaßen. Die Belichtungseigenschaften des lichtempfindlichen Aufzeichnungselements waren nach 3-monatiger Lagerung unverändert.

Beispiel 8

174 Teile eines N-Vinylpyrrolidon-Vinylacetat-Copolymerisats (Comonomer-Verhältnis 60:40) mit einem K-Wert von 32 und 75 Teile eines teilverseiften Polyvinylacetats, das 22 % Polyoxyethylensegmente gebunden enthielt, mit einem Molekulargewicht (Gewichtsmittel) von 25 000 bis 30 000 wurden in 210 Teilen entsalztem Wasser gelöst. Sodann wurden 6,0 Teile α-Methylolbenzoinmethylether, 0,1 Teile N-Nitrosocyclohexylhydroxylamin und 0,015 Teile Eosin in 45 Teilen 1,1,1-Trimethylolpropantriacrylat eingerührt. Aus dieser Lösung wurde, wie in Beispiel 1, eine 500 µm dicke lichtempfindliche, fotopolymerisierbare Schicht hergestellt und diese auf ein mit einer Haftschicht versehenes Aluminiumblech aufgebracht. Die 8 µm starke Haftschicht enthielt 4 % des Farbstoffs der Formel (IV). Dieses so hergestellte lichtempfindliche Aufzeichnungselement wurde in üblicher Weise bildmäßig mit aktinischem Licht belichtet und anschließend zu einer Druckform entwickelt. Die erhaltene Druckform wies eine sehr gute Reliefstruktur auf.

Beispiel 9

1036 Teile eines teilverseiften Polyvinylacetats (Verseifungsgrad 82 Mol%; mittlerer Polymerisationsgrad 500 bis 600) wurden in 1050 Teilen entsalztem Wasser gelöst. Sodann wurde eine Lösung von 37 Teilen Tetraethylenglykoldimethacrylat, 29 Teilen Benzildimethylketal, 2,9 Teilen 2,6-Di-t.-butyl-p-kresol und 0,1 Teilen Eosin in 880 Teilen 2-Hydroxyethylmethacrylat hinzugefügt. Aus dieser Lösung wurde eine lichtempfindliche, fotopolymerisierbare Schicht gegossen, die nach dem Abdampfen des Lösungsmittels und Trocknen eine Schichtdicke von etwa 500 µm aufwies. Die lichtempfindliche, fotopolymerisierbare Schicht wurde auf ein mit einer 10 µm starken Haftschicht versehenes Stahlblech aufkaschiert. Die Haftschicht enthielt dabei 3 % des Farbstofts Direct Yellow 11 (C.I. 40 000). Nach bildmäßigem Belichten der lichtempfindlichen, fotopolymerisierbaren Aufzeichnungsschicht des so hergestellten Aufzeichnungselementes und Auswaschen der nicht belichteten Schichtbereiche mit Wasser wurde eine Reliefdruckplatte mit guten Zwischentiefen erhalten.

Beispiel 10

400 Teile eines teilverseiften Polyvinylacetats (Verseifungsgrad 83 Mol%) mit einem Molekulargewicht (Gewichtsmittel) von ca. 30 000 und 171 Teile eines teilverseiften Polyvinylacetats, das 22 % Polyoxyethylensegmente gebunden enthielt, mit einem Molekulargewicht (Gewichtsmittel) von etwa 25 000 bis 30 000 wurden in 573 Teilen entsalztem Wasser gelöst. Sodann wurden 86,5 Teile Butandiol-1,4-dimethacrylat, 6,8 Teile 2,4,6-Trimethylbenzoyldiphenylphosphinoxid und 1,8 Teile 2,6-Di-t.-butyl-p-kresol in 506 Teilen 2-Hydroxyethylmethacrylat zugesetzt. Die aus dieser Lösung gegossene lichtempfindliche, fotopolymerisierbare Schicht hatte nach dem Abdampfen des Lösungsmittels und Trocknen eine Schichtdicke von ca. 500 µm.

In vorstehender Weise hergestellte lichtempfindliche, fotopolymerisierbare Schichten wurden auf Aluminiumbleche aufkaschiert, die jeweils mit einer Haftschicht versehen waren. Die jeweils 10 µm starken Haftschichten wurden gebildet aus einer Mischung von 80 % des in der lichtempfindlichen, fotopolymerisierbaren Aufzeichnungsschicht enthaltenen teilverseiften Polyvinylacetats (Verseifungsgrad 83 Mol%, $M_w$ ca. 30 000) und 20% 2-Hydroxyethylmethacrylat und Einbrennen dieser Schichten. Die Haftschichten enthielten dabei unterschiedliche Mengen des Farbstoffes Direct Yellow 11 (C.I. 40 000).

Die so erhaltenen lichtempfindlichen Aufzeichnungselemente wurden in einem handelsüblichen Belichter mit einem dotierten 5 kW-Quecksilberbrenner zunächst kurz vollflächig vorbelichtet und anschließend in einer Hauptbelichtung bildmäßig belichtet. Es wurden die Mindestbelichtungszeiten ermittelt, die zur Ausbildung einer guten Reliefstruktur notwendig waren. Die Farbstoffkonzentrationen in den Haftschichten, die ermittelten Mindestbelichtungszeiten sowie die an den erhaltenen Reliefformen gemessenen Zwischentiefen sowohl im Rasterfeld als auch bei einem negativen Punkt sind in der Tabelle 2 zusammengestellt. Wie Tabelle 2 zeigt, reicht bereits eine Konzentration des Farbstoffes in der Haftschicht von 2 % aus, um ausgezeichnete Zwischentiefen in den negativen Bildelementen zu erzielen.

Tabelle 2

| Farbstoff-konzentration [%] | Mindest-belichtungszeit (Vor-/Hauptbelichtung) [Sek.] | Zwischentiefen [µm] 60-proz. Raster, (32 L./cm) | neg. Punkt, Durchm. 400 µm |
|---|---|---|---|
| 0 | 2/25 | 17 | 41 |
| 2 | 2/25 | 130 | 234 |
| 4 | 2,2/33 | 132 | 274 |
| 6 | 2,2/38 | 134 | 268 |
| 8 | 2,5/38 | 130 | 267 |

Beispiel 11

Mit der gleichen Rezeptur wie in Beispiel 10 wurde eine lichtempfindliche, fotopolymerisierbare Schicht hergestellt, die diesmal jedoch aus 2 Lagen aufgebaut war, von denen die untere, 100 µm starke Lage zusätzlich 0,2 % des Farbstoffs Direct Yellow 11 (C.I. 40 000) enthielt. Die obere, 400 µm starke Lage der lichtempfindlichen, fotopolymerisierbaren Aufzeichnungsschicht enthielt keinen Farbstoff. Das Belichtungsverhalten dieser lichtempfindlichen, fotopolymerisierbaren Aufzeichnungsschicht war unabhängig von der Art des verwendeten Trägers und der hierauf befindlichen Haftschicht und entsprach dem des Aufzeichnungselementes mit 2 % Farbstoff in der Haftschicht des Beispiels 10.

## Ansprüche

Patentansprüche für folgende Vertragsstaaten : BE, CH, DE, FR, GB, IT, LI, NL, SE

1. Lichtempfindliches Aufzeichnungselement, insbesondere für die Herstellung von Druck-, Reliefformen oder Resistmustern, mit
   (a) einem dimensionsstabilen Träger,
   (b) einer auf dem Träger aufgebrachten, festen lichtempfindlichen Aufzeichnungsschicht,
   sowie gegebenenfalls
   (c) einer oder mehreren Zwischenschichten zwischen dem Träger und der lichtempfindlichen Aufzeichnungsschicht,
   welches in der lichtempfindlichen Aufzeichnungsschicht und/oder einer gegebenenfalls vorhandenen Zwischenschicht einen Farbstoff enthält, dadurch gekennzeichnet, daß als Farbstoff eine Verbindung der allgemeinen Formel (I)

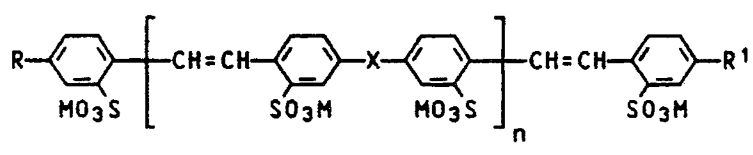

(I)

enthalten ist, worin bedeuten

X : eine Azo- oder Azoxigruppierung,

M : ein Wasserstoffatom, ein Alkalimetall-Kation, das Ammonium-oder ein Amin-Kation,

R, $R^1$ : gleich oder verschieden und unabhängig voneinander, eine $-NO_2$-Gruppe, eine $NH_2$-Gruppe, eine $-NHCOR^2$-Gruppe (mit $R^2$ = einem Wasserstoffatom, einem gegebenenfalls substituierten Alkylrest, einem gegebenenfalls substituierten Cycloalkylrest, einem gegebenenfalls substituierten Phenylrest, einem Alkoxyrest, einem Phenoxyrest, einem 5- oder 6-gliedrigen heteroaromatischen Rest, einer $NH_2$-Gruppe oder einer -COOH-Gruppe), eine

-$NHSO_2R^3$-Gruppe (mit $R^3$ = einem Alkyl-oder Phenylrest) oder eine -N=N-$R^4$-Gruppe (mit $R^4$ = dem Rest einer Kupplungskomponente),

n : eine ganze Zahl von 1 bis 6 und für den Fall, daß R und/oder $R^1$ eine -N=N-$R^4$-Gruppe darstellen, auch 0.

**2.** Lichtempfindliches Aufzeichnungselement nach Anspruch 1, dadurch gekennzeichnet, daß es als Farbstoff eine Verbindung der allgemeinen Formel (I) enthält, worin wenigstens einer, vorzugsweise beide, der Reste R und $R^1$ eine -$NO_2$-Gruppe bedeuten.

**3.** Lichtempfindliches Aufzeichnungselement nach Anspruch 1, dadurch gekennzeichnet, daß es als Farbstoff eine Verbindung der allgemeinen Formel (I) enthält, worin wenigstens einer, vorzugsweise beide, der Reste R und $R^1$ eine -$NH_2$-Gruppe bedeuten.

**4.** Lichtempfindliches Aufzeichnungselement nach Anspruch 1, dadurch gekennzeichnet, daß es als Farbstoff eine Verbindung der allgemeinen Formel (I) enthält, worin wenigstens einer der Reste R oder $R^1$ eine -$NHCOR^2$-Gruppe bedeutet, wobei $R^2$ steht für einen Alkyl- oder gegebenenfalls substituierten Phenylrest.

**5.** Lichtempfindliches Aufzeichnungselement gemäß Anspruch 1, dadurch gekennzeichnet, daß es als Farbstoff eine Verbindung der allgemeinen Formel (I) enthält, worin wenigstens einer der Reste R und $R^1$ für eine -N=N-$R^4$-Gruppe mit $R^4$ gleich dem Rest einer wasserlöslichen Kupplungskomponente, insbesondere der Benzol- oder Naphthalinreihe, steht.

**6.** Lichtempfindliches Aufzeichnungselement nach einem der Ansprüche 1 bis 5, dadurch gekennzeichnet, daß es als Farbstoff eine Verbindung der allgemeinen Formel (I) enthält, worin n eine ganze Zahl von 1 bis 3 ist und für den Fall, daß wenigstens einer der Reste R und $R^1$ eine -N=N-$R^4$-Gruppe darstellt, auch 0 sein kann.

**7.** Lichtempfindliches Aufzeichnungselement nach einem der Ansprüche 1 bis 6, dadurch gekennzeichnet, daß der Farbstoff in der lichtempfindlichen Aufzeichnungsschicht in über die Schichtdicke hinweg abgestufter Konzentration enthalten ist.

**8.** Lichtempfindliches Aufzeichnungselement nach einem der Ansprüche 1 bis 7, dadurch gekennzeichnet, daß die lichtempfindliche Aufzeichnungsschicht mehrlagig ausgebildet ist und der Farbstoff in benachbarten Lagen der lichtempfindlichen Aufzeichnungsschicht in unterschiedlichen Konzentrationen enthalten ist, wobei die Konzentration in einzelnen Lagen auch 0 sein kann.

**9.** Lichtempfindliches Aufzeichnungselement nach einem der Ansprüche 1 bis 8, dadurch gekennzeichnet, daß es mindestens eine Zwischenschicht aufweist, in der der Farbstoff in unterschiedlicher Konzentration zu der lichtempfindlichen Aufzeichnungsschicht enthalten ist, wobei die Konzentration des Farbstoffes in der Zwischenschicht oder der lichtempfindlichen Aufzeichnungsschicht auch 0 sein kann.

**10.** Lichtempfindliches Aufzeichnungselement nach Anspruch 9, dadurch gekennzeichnet, daß der Farbstoff der allgemeinen Formel (I) nur in der Zwischenschicht enthalten ist.

**11.** Lichtempfindliches Aufzeichnungselement nach einem der Ansprüche 7 bis 10, dadurch gekennzeichnet, daß die Farbstoffkonzentration über die Dicke des Aufzeichnungselementes hinweg vom Träger zur äußeren Oberfläche der lichtempfindlichen Aufzeichnungsschicht hin abnimmt.

**12.** Lichtempfindliches Aufzeichnungselement nach einem der Ansprüche 1 bis 11, dadurch gekennzeichnet, daß die lichtempfindliche Aufzeichnungsschicht aus einem fotopolymerisierbaren Gemisch gebildet wird, welches mindestens eine ethylenisch ungesättigte, photopolymerisierbare Verbindung und mindestens einen Fotoinitiator enthält.

**13.** Lichtempfindliches Aufzeichnungselement nach einem der Ansprüche 1 bis 12, dadurch gekennzeichnet, daß die lichtempfindliche Aufzeichnungsschicht wäßrig entwickelbar ist und mindestens ein in wäßrigen Entwicklerlösungen lösliches oder zumindest dispergierbares polymeres Bindemittel, mindestens eine ethylenisch ungesättigte, fotopolymerisierbare niedermolekulare Verbindung, die mit dem

polymeren Bindemittel verträglich ist, und mindestens einen Fotopolymerisationsinitiator enthält.

14. Lichtempfindliches Aufzeichnungselement nach Anspruch 13, dadurch gekennzeichnet, daß die lichtempfindliche Aufzeichnungsschicht als polymeres Bindemittel ein Vinylalkoholpolymerisat oder ein Derivat eines Vinylalkoholpolymerisats enthält.

Patentansprüche für folgende Vertragsstaaten : AT, ES

1. Verfahren zur Herstellung von Druck- oder Reliefformen oder Resistmustern durch bildmäßiges Belichten mit aktinischem Licht und Entwickeln eines lichtempfindlichen Aufzeichnungselements mit
(a) einem dimensionsstabilen Träger,
(b) einer auf dem Träger aufgebrachten, festen lichtempfindlichen Aufzeichnungsschicht,
sowie gegebenenfalls
(c) einer oder mehreren Zwischenschichten zwischen dem Träger und der lichtempfindlichen Aufzeichnungsschicht,
wobei das lichtempfindliche Aufzeichnungselement in der lichtempfindlichen Aufzeichnungsschicht und/oder einer gegebenenfalls vorhandenen Zwischenschicht einen Farbstoff enthält, dadurch gekennzeichnet, daß als Farbstoff eine Verbindung der allgemeinen Formel (I)

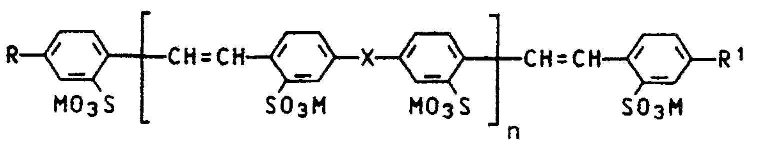 (I)

enthalten ist, worin bedeuten
X: eine Azo- oder Azoxigruppierung,
M: ein Wasserstoffatom, ein Alkalimetall-Kation, das Ammonium-oder ein Amin-Kation,
R, $R^1$: gleich oder verschieden und unabhängig voneinander, eine $-NO_2$-Gruppe, eine $NH_2$-Gruppe, eine $-NHCOR^2$-Gruppe (mit $R^2$ = einem Wasserstoffatom, einem gegebenenfalls substituierten Alkylrest, einem gegebenenfalls substituierten Cycloalkylrest, einem gegebenenfalls substituierten Phenylrest, einem Alkoxyrest, einem Phenoxyrest, einem 5- oder 6-gliedrigen heteroaromatischen Rest, einer $NH_2$-Gruppe oder einer -COOH-Gruppe), eine $-NHSO_2R^3$-Gruppe (mit $R^3$ = einem Alkyl-oder Phenylrest) oder eine $-N=N-R^4$-Gruppe (mit $R^4$ = dem Rest einer Kupplungskomponente),
n: eine ganze Zahl von 1 bis 6 und für den Fall, daß R und/oder $R^1$ eine $-N=N-R^4$-Gruppe darstellen, auch 0.

2. Verfahren nach Anspruch 1, dadurch gekennzeichnet, daß das lichtempfindliche Aufzeichnungselement als Farbstoff eine Verbindung der allgemeinen Formel (I) enthält, worin wenigstens einer, vorzugsweise beide, der Reste R und $R^1$ eine $-NO_2$-Gruppe bedeuten.

3. Verfahren nach Anspruch 1, dadurch gekennzeichnet, daß das lichtempfindliche Aufzeichnungselement als Farbstoff eine Verbindung der allgemeinen Formel (I) enthält, worin wenigstens einer, vorzugsweise beide, der Reste R und $R^1$ eine $-NH_2$-Gruppe bedeuten.

4. Verfahren nach Anspruch 1, dadurch gekennzeichnet, daß das lichtempfindliche Aufzeichnungselement als Farbstoff eine Verbindung der allgemeinen Formel (I) enthält, worin wenigstens einer der Reste R oder $R^1$ eine $-NHCOR^2$-Gruppe bedeutet, wobei $R^2$ steht für einen Alkyl- oder gegebenenfalls substituierten Phenylrest.

5. Verfahren gemäß Anspruch 1, dadurch gekennzeichnet, daß das lichtempfindliche Aufzeichnungselement als Farbstoff eine Verbindung der allgemeinen Formel (I) enthält, worin wenigstens einer der Reste R und $R^1$ für eine $-N=N-R^4$-Gruppe mit $R^4$ gleich dem Rest einer wasserlöslichen Kupplungskomponente, insbesondere der Benzol- oder Naphthalinreihe, steht.

6. Verfahren nach einem der Ansprüche 1 bis 5, dadurch gekennzeichnet, daß das lichtempfindliche

Aufzeichnungselement als Farbstoff eine Verbindung der allgemeinen Formel (I) enthält, worin n eine ganze Zahl von 1 bis 3 ist und für den Fall, daß wenigstens einer der Reste R und $R^1$ eine -N=N-$R^4$-Gruppe darstellt, auch 0 sein kann.

7. Verfahren nach einem der Ansprüche 1 bis 6, dadurch gekennzeichnet, daß der Farbstoff in der lichtempfindlichen Aufzeichnungsschicht in über die Schichtdicke hinweg abgestufter Konzentration enthalten ist.

8. Verfahren nach einem der Ansprüche 1 bis 7, dadurch gekennzeichnet, daß die lichtempfindliche Aufzeichnungsschicht mehrlagig ausgebildet ist und der Farbstoff in benachbarten Lagen der lichtempfindlichen Aufzeichnungsschicht in unterschiedlichen Konzentrationen enthalten ist, wobei die Konzentration in einzelnen Lagen auch 0 sein kann.

9. Verfahren nach einem der Ansprüche 1 bis 8, dadurch gekennzeichnet, daß das lichtempfindliche Aufzeichnungselement mindestens eine Zwischenschicht aufweist, in der der Farbstoff in unterschiedlicher Konzentration zu der lichtempfindlichen Aufzeichnungsschicht enthalten ist, wobei die Konzentration des Farbstoffes in der Zwischenschicht oder der lichtempfindlichen Aufzeichnungsschicht auch 0 sein kann.

10. Verfahren nach Anspruch 9, dadurch gekennzeichnet, daß der Farbstoff der allgemeinen Formel (I) nur in der Zwischenschicht enthalten ist.

11. Verfahren nach einem der Ansprüche 7 bis 10, dadurch gekennzeichnet, daß die Farbstoffkonzentration über die Dicke des Aufzeichnungselementes hinweg vom Träger zur äußeren Oberfläche der lichtempfindlichen Aufzeichnungsschicht hin abnimmt.

12. Verfahren nach einem der Ansprüche 1 bis 11, dadurch gekennzeichnet, daß die lichtempfindliche Aufzeichnungsschicht aus einem fotopolymerisierbaren Gemisch gebildet wird, welches mindestens eine ethylenisch ungesättigte, photopolymerisierbare Verbindung und mindestens einen Fotoinitiator enthält.

13. Verfahren nach einem der Ansprüche 1 bis 12, dadurch gekennzeichnet, daß die lichtempfindliche Aufzeichnungsschicht wäßrig entwickelbar ist und mindestens ein in wäßrigen Entwicklerlösungen lösliches oder zumindest dispergierbares polymeres Bindemittel, mindestens eine ethylenisch ungesättigte, fotopolymerisierbare niedermolekulare Verbindung, die mit dem polymeren Bindemittel verträglich ist, und mindestens einen Fotopolymerisationsinitiator enthält.

14. Verfahren nach Anspruch 13, dadurch gekennzeichnet, daß die lichtempfindliche Aufzeichnungsschicht als polymeres Bindemittel ein Vinylalkoholpolymerisat oder ein Derivat eines Vinylalkoholpolymerisats enthält.

**Claims**

Claims for the following Contracting States : BE, CH, DE, FR, GB, IT, LI, NL, SE

1. A photosensitive recording element, in particular for the production of printing plates, relief plates or resist images, having

(a) a dimensionally stable base,

(b) a solid photosensitive recording layer applied on the base

with or without

(c) one or more intermediate layers between the base and the photosensitive recording layer,

and containing, in the photosensitive recording layer and/or, where present, in an intermediate layer, a dye, wherein the dye is a compound of the formula (I)

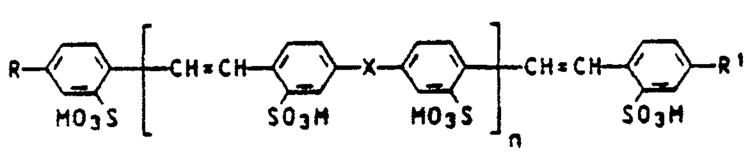

(I)

where X is an azo or azoxy group, M is hydrogen, an alkali metal cation, ammonium or an amine cation, R and $R^1$ are identical or different and independently of one another are each $-NO_2$, $-NH_2$, $-NHCOR^2$ (in which $R^2$ is hydrogen, unsubstituted or substituted alkyl, unsubstituted or substituted cycloalkyl, unsubstituted or substituted phenyl, alkoxy, phenoxy, a 5-membered or 6-membered heteroaromatic radical, $-NH_2$, or -COOH), $-NHSO_2R^3$ (in which $R^3$ is alkyl or phenyl) or $-N=N-R^4$ (in which $R^4$ is a radical of a coupling component), and n is an integer from 1 to 6 and, where R and/or $R^1$ is $-N=N-R^4$, may furthermore be 0.

**2.** A photosensitive recording element as claimed in claim 1, which contains, as the dye, a compound of the formula (I) where one or both, preferably both, of the radicals R and $R^1$ are $-NO_2$.

**3.** A photosensitive recording element as claimed in claim 1, which contains, as the dye, a compound of the formula (I) where one or both, preferably both, of the radicals R and $R^1$ are $-NH_2$.

**4.** A photosensitive recording element as claimed in claim 1, which contains, as the dye, a compound of the formula (I) where one or both of the radicals R and $R^1$ is $-NHCOR^2$, where $R^2$ is alkyl or unsubstituted or substituted phenyl.

**5.** A photosensitive recording element as claimed in claim 1, which contains, as the dye, a compound of the formula (I) where one or both of the radicals R and $R^1$ is $-N=N-R^4$, where $R^4$ is a radical of a water-soluble coupling component, in particular the benzene or naphthalene series.

**6.** A photosensitive recording element as claimed in any of claims 1 to 5, which contains, as the dye, a compound of the formula (I) where n is an integer from 1 to 3 and, if one or both of the radicals R and $R^1$ are $-N=N-R^4$, may furthermore be 0.

**7.** A photosensitive recording element as claimed in any of claims 1 to 6, wherein the dye is present in the photosensitive recording layer in concentrations graded over the layer thickness.

**8.** A photosensitive recording element as claimed in any of claims 1 to 7, wherein the photosensitive recording layer is in the form of a plurality of layers, and the dye is present in different concentrations in adjacent layers of the photosensitive recording layer, and the concentration in individual layers may furthermore be 0.

**9.** A photosensitive recording element as claimed in any of claims 1 to 8, which has one or more intermediate layers, wherein the dye is present in a concentration which differs from that in the photosensitive recording layer, and the concentration of the dye in the intermediate layer or in the photosensitive recording layer may furthermore be 0.

**10.** A photosensitive recording element as claimed in claim 9, wherein the dye of the formula (I) is present only in the intermediate layer.

**11.** A photosensitive recording element as claimed in any of claims 7 to 10, wherein the dye concentration decreases over the thickness of the recording element, from the base to the outer surface of the photosensitive recording layer.

**12.** A photosensitive recording element as claimed in any of claims 1 to 11, wherein the photosensitive recording layer consists of a photopolymerizable mixture which contains one or more ethylenically unsaturated, photopolymerizable compounds and one or more photoinitiators.

**13.** A photosensitive recording element as claimed in any of claims 1 to 12, wherein the photosensitive recording layer can be developed with an aqueous medium and contains one or more polymeric binders which are soluble or dispersible in aqueous developers, one or more ethylenically unsaturated photopolymerizable, low molecular weight compounds which are compatible with the polymeric binder, and one or more photopolymerization initiators.

**14.** A photosensitive recording element as claimed in claim 13, wherein the photosensitive recording layer contains a vinyl alcohol polymer or a derivative thereof as the polymeric binder.

Claims for the following Contracting States : AT, ES

1. A process for the production of printing plates, relief plates or resist images by imagewise exposure to actinic light and development of a photosensitive recording element, having
   (a) a dimensionally stable base,
   (b) a solid photosensitive recording layer applied on the base
   with or without
   (c) one or more intermediate layers between the base and the photosensitive recording layer,
   said element containing, in the photosensitive recording layer and/or, where present, in an intermediate layer, a dye, wherein the dye is a compound of the formula (I)

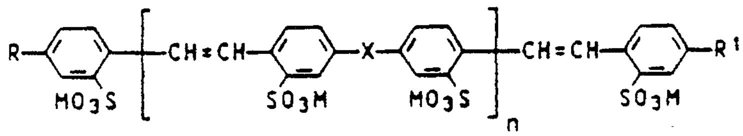

(I)

where X is an azo or azoxy group, M is hydrogen, an alkali metal cation, ammonium or an amine cation, R and $R^1$ are identical or different and independently of one another are each $-NO_2$, $-NH_2$, $-NHCOR^2$ (in which $R^2$ is hydrogen, unsubstituted or substituted alkyl, unsubstituted or substituted cycloalkyl, unsubstituted or substituted phenyl, alkoxy, phenoxy, a 5-membered or 6-membered heteroaromatic radical, $-NH_2$ or -COON), $-NHSO_2R^3$ (in which $R^3$ is alkyl or phenyl) or $-N=N-R^4$ (in which $R^4$ is a radical of a coupling component), and n is an integer from 1 to 6 and, where R and/or $R^1$ is $-N=N-R^4$, may furthermore be 0.

2. A process as claimed in claim 1, wherein the photosensitive recording element contains, as the dye, a compound of the formula (I) where one or both, preferably both, of the radicals R and $R^1$ are -NH2.

3. A process as claimed in claim 1, wherein the photosensitive recording element contains, as the dye, a compound of the formula (I) where one or both, preferably both, of the radicals R and $R^1$ are $-NH_2$.

4. A process as claimed in claim 1, wherein the photosensitive recording element contains, as the dye, a compound of the formula (I) where one or both of the radicals R and $R^1$ is $-NHCOR^2$, where $R^2$ is alkyl or unsubstituted or substituted phenyl.

5. A process as claimed in claim 1, wherein the photosensitive recording element contains, as the dye, a compound of the formula (I) where one or both of the radicals R and $R^1$ is $-N=N-R^4$, where $R^4$ is a radical of a water-soluble coupling component, in particular of the benzene or naphthalene series.

6. A process as claimed in any of claims 1 to 5, wherein a photosensitive recording element contains, as the dye, a compound of the formula (I), where n is an integer from 1 to 3 and, if one or both of the radicals R and $R^1$ are $-N=N-R^4$, may furthermore be 0.

7. A process as claimed in any of claims 1 to 6, wherein the dye is present in the photosensitive recording layer in concentrations graded over the layer thickness.

8. A process as claimed in any of claims 1 to 7, wherein the photosensitive recording layer is in the form of a plurality of layers, and the dye is present in different concentrations in adjacent layers of the photosensitive recording layer, and the concentration in individual layers may furthermore be 0.

9. A process as claimed in any of claims 1 to 8, wherein the photosensitive recording element has one or more intermediate layers, where the dye is present in a concentration which differs from that in the photosensitive recording layer, and the concentration of the dye in the intermediate layer or in the photosensitive recording layer may furthermore be 0.

10. A process as claimed in claim 9, wherein the dye of the formula (I) is present only in the intermediate layer.

11. A process as claimed in any of claims 7 to 10, wherein the dye concentration decreases over the thickness of the recording element, from the base to the outer surface of the photosensitive recording layer.

12. A process as claimed in any of claims 1 to 11, wherein the photosensitive recording layer consists of a photopolymerizable mixture which contains one or more ethylenically unsaturated, photopolymerizable compounds and one or more photoinitiators.

13. A process as claimed in any of claims 1 to 12, wherein the photosensitive recording layer can be developed with an aqueous medium and contains one or more polymeric binders which are soluble or dispersible in aqueous developers, one or more ethylenically unsaturated photopolymerizable, low molecular weight compounds which are compatible with the polymeric binder, and one or more photopolymerization initiators.

14. A process as claimed in claim 13, wherein the photosensitive recording layer contains a vinyl alcohol polymer or a derivative thereof as the polymeric binder.

**Revendications**

Revendications pour les Etats contractants suivants : BE, CH, DE, FR, GB, IT, LI, NL, SE

1. Elément d'enregistrement sensible à la lumière, en particulier pour la fabrication de formes d'impression, à relief ou de modèles de réserve (resist), comprenant
   a) un support stable en dimensions
   b) une couche d'enregistrement solide, sensible à la lumière, appliquée sur le support

   ainsi qu'éventuellement
   c) une ou plusieurs couches intermédiaires entre le support et la couche d'enregistrement sensible à la lumière

   qui contient un colorant dans la couche d'enregistrement sensible à la lumière et/ou dans une couche intermédiaire éventuellement présente, caractérisé par le fait que, comme colorant, est contenu un composé de la formule générale (I)

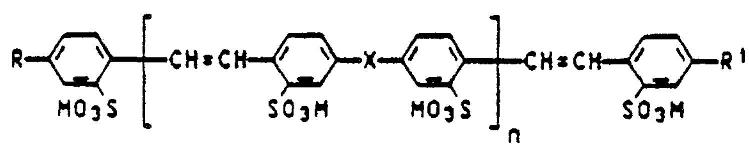

   dans laquelle

   X représente un groupement azo ou azoxy

   M, un atome d'hydrogène, un cation de métal alcalin, le cation ammonium ou un cation d'amine

   R,R' identiques ou différents et indépendants l'un de l'autre, un groupe $-NO_2$, un groupe $NH_2$, un groupe $-NHCOR^2$ (avec $R^2$ = un atome d'hydrcgène, un reste alkyle éventuellement substitué, un reste cycloalkyle éventuellement substitué, un reste phényle éventuellement substitué, un reste alcoxy, un reste phénoxy, un reste hétéroaromatique à 5 ou 6 chaînons, un groupe $NH_2$ ou un groupe -COOH), un groupe $-NHSO_2R^3$ (avec $R^3$ = un reste alkyle ou un reste phényle) ou un groupe $-N=N-R^4$ (avec $R^4$ = le reste d'un composant de copulation)

   n, un nombre entier de 1 à 6 et aussi 0 dans le cas où R et/ou R' représentent un groupe $-N=N-R^4$.

2. Elément d'enregistrement sensible à la lumière selon la revendication 1, caractérisé par le fait que l'élement d'enregistrement sensible à la lumière contient, comme colorant, un composé de la formule générale (I), où au moins un, avantageusement les deux, des restes R et R' représentent un groupe $-NO_2$.

3. Elément d'enregistrement sensible à la lumière selon la revendication 1, caractérisé par le fait que l'élément d'enregistrement sensible à la lumière contient, comme colorant, un composé de la formule

générale (I), où au moins un, avantageusement les deux, des restes R et $R^1$ représentent un groupe $-NH_2$.

4. Elément d'enregistrement sensible à la lumière selon la revendication 1, caractérisé par le fait que l'élément d'enregistrement sensible à la lumière contient, comme colorant, un composé de la formule générale (I), où au moins un des restes R ou $R^1$ représentent un groupe $-NHCOR^2$, $R^2$ étant mis pour un reste alkyle ou un reste phényle éventuellement substitué.

5. Elément d'enregistrement sensible à la lumière selon la revendication 1, caractérisé par le fait que l'élément d'enregistrement sensible à la lumière contient, comme colorant, un composé de la formule générale (I), où au moins un des restes R et $R^1$ est mis pour un groupe $-N=N-R^4$, avec $R^4$ identique au reste d'un composant de copulation soluble dans l'eau, en particulier de la série du benzène ou du naphtalène.

6. Elément d'enregistrement sensible à la lumière selon l'une des revendications 1 à 5, caractérisé par le fait que l'élément d'enregistrement sensible à la lumière contient, comme colorant, un composé de la formule générale (I), où n est un nombre entier de 1 à 3 et peut aussi être 0 dans le cas où au moins un des restes R et $R_1$ représente un groupe $-N=N-R_4$.

7. Elément d'enregistrement sensible à la lumière selon l'une des revendications 1 à 6, caractérisé par le fait que le colorant est contenu, dans la couche d'enregistrement sensible à la lumière, en une concentration échelonnée sur l'épaisseur de la couche.

8. Elément d'enregistrement sensible à la lumière selon l'une des revendications 1 à 7, caractérisé par le fait que le couche d'enregistrement sensible à la lumière est formée de plusieurs couches et le colorant est contenu dans des couches voisines de la couche d'enregistrement sensible à la lumière en des concentrations différentes, la concentration dans certaines couches pouvant être aussi 0.

9. Elément d'enregistrement sensible à la lumière selon l'une des revendications 1 à 8, caractérisé par le fait que la couche d'enregistrement sensible à la lumière comporte au moins une couche intermédiaire dans laquelle le colorant est contenu en concentration différente de la couche d'enregistrement sensible à la lumière, la concentration du colorant dans la couche intermédiaire ou la couche d'enregistrement sensible à la lumière pouvant aussi être 0.

10. Elément d'enregistrement sensible à la lumière selon la revendication 9, caractérisé par le fait que le colorant de la formule générale (I) n'est contenu que dans la couche intermédiaire.

11. Elément d'enregistrement sensible à la lumière selon l'une des revendications 7 à 10, caractérisé par le fait que la concentration du colorant échelonnée sur l'épaisseur de l'élément d'enregistrement va en diminuant du support à la surface extérieure de la couche d'enregistrement sensible à la lumière.

12. Elément d'enregistrement sensible à la lumière selon l'une des revendications 1 à 11, caractérisé par le fait que la couche d'enregistrement sensible à la lumière est formée d'un mélange photopolymérisable qui contient au moins un composé photopolymérisable, insaturé éthyléniquement et au moins un photoinitiateur.

13. Elément d'enregistrement sensible à la lumière selon l'une des revendications 1 à 12, caractérisé par le fait que la couche d'enregistrement sensible à la lumière est développable par voie aqueuse et contient au moins un liant polymère soluble ou au moins dispersable dans des solutions de développement aqueuses, au moins un composé à bas poids moléculaire, photopolymérisable, insaturé éthyléniquement, qui est compatible avec le liant polymère, et au moins un initiateur de photopolymérisation.

14. Elément d'enregistrement sensible à la lumière selon la revendication 13, caractérisé par le fait que la couche d'enregistrement sensible à la lumière contient, comme liant polymère, un polymérisat d'alcool vinylique ou un dérivé d'un polymérisat d'alcool vinylique.

Revendications pour les Etats contractants suivants : AT, ES

1. Procédé de fabrication de formes d'impression ou a relief ou de modèles de réserve (resist) par exposition selon une image, à une lumière actinique et développement d'un élément d'enregistrement sensible à la lumière avec

a) un support stable en dimensions

b) une couche d'enregistrement solide, sensible à la lumière, appliquée sur le support

ainsi qu'éventuellement

c) une ou plusieurs couches intermédiaires entre le support et la couche d'enregistrement sensible à la lumière

l'élément d'enregistrement sensible à la lumière, contenant un colorant dans la couche d'enregistrement sensible à la lumière et/ou dans une couche intermédiaire éventuellement présente, caractérisé par le fait que, comme colorant, est contenu un composé de la formule générale (I)

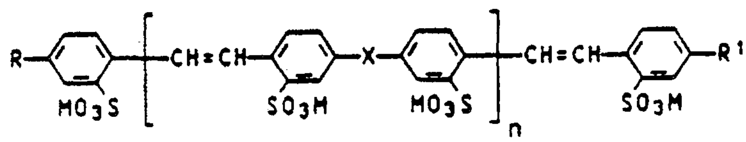

dans laquelle

X représente un groupement azo ou azoxy

M, un atome d'hydrogène, un cation de métal alcalin, le cation ammonium ou un cation d'amine

R,R' identiques ou différents et indépendants l'un de l'autre, un groupe $-NO_2$, un groupe $NH_2$, un groupe $-NHCOR^2$ (avec $R^2$ = un atome d'hydrogène, un reste alkyle éventuellement substitué, un reste cycloalkyle éventuellement substitué, un reste phényle éventuellement substitué, un reste alcoxy, un reste phénoxy, un reste hétéroaromatique à 5 ou 6 chaînons, un groupe $NH_2$ ou un groupe -COOH), un groupe $-NHSO_2R^3$ (avec $R^3$ = un reste alkyle ou un reste phényle) ou un groupe $-N=N-R^4$ (avec $R^4$ = le reste d'un composant de copulation)

n, un nombre entier de 1 à 6 et aussi 0 dans le cas où R et/ou R' représentent un groupe $-N=N-R^4$.

2. Procédé selon la revendication 1, caractérisé par le fait que l'élement d'enregistrement sensible à la lumière contient, comme colorant, un composé de la formule générale (I), où au moins un, avantageusement les deux, des restes R et R' représentent un groupe $-NO_2$.

3. Procédé selon la revendication 1, caractérisé par le fait que l'élément d'enregistrement sensible à la lumière contient, comme colorant, un composé de la formule générale (I), où au moins un, avantageusement les deux, des restes R et $R^1$ représentent un groupe $-NH_2$.

4. Procédé selon la revendication 1, caractérisé par le fait que l'élément d'enregistrement sensible à la lumière contient, comme colorant, un composé de la formule générale (I), où au moins un des restes R ou $R^1$ représentent un groupe $-NHCOR^2$, $R^2$ étant mis pour un reste alkyle ou un reste phényle éventuellement substitué.

5. Procédé selon la revendication 1, caractérisé par le fait que l'élément d'enregistrement sensible à la lumière contient, comme colorant, un composé de la formule générale (I), où au moins un des restes R et $R^1$ est mis pour un groupe $-N=N-R^4$, avec $R^4$ identique au reste d'un composant de copulation soluble dans l'eau, en particulier de la série du benzène ou du naphtalène.

6. Procédé selon l'une des revendications 1 à 5, caractérisé par le fait que l'élément d'enregistrement sensible à la lumière contient, comme colorant, un composé de la formule générale (I), où n est un nombre entier de 1 à 3 et peut aussi être 0 dans le cas où au moins un des restes R et $R^1$ représente un groupe $-N=N-R^4$.

7. Procédé selon l'une des revendications 1 à 6, caractérisé par le fait que le colorant est contenu, dans la couche d'enregistrement sensible à la lumière, en une concentration échelonnée sur l'épaisseur de

la couche.

8. Procédé selon l'une des revendications 1 à 7, caractérisé par le fait que le couche d'enregistrement sensible à la lumière est formée de plusieurs couches et le colorant est contenu dans des couches voisines de la couche d'enregistrement sensible à la lumière en des concentrations différentes, la concentration dans certaines couches pouvant être aussi 0.

9. Procédé selon l'une des revendications 1 à 8, caractérisé par le fait que la couche d'enregistrement sensible à la lumière comporte au moins une couche intermédiaire dans laquelle le colorant est contenu en concentration différente de la couche d'enregistrement sensible à la lumière, la concentration du colorant dans la couche intermédiaire ou la couche d'enregistrement sensible à la lumière pouvant aussi être 0.

10. Procédé selon la revendication 9, caractérisé par le fait que le colorant de la formule générale (I) n'est contenu que dans la couche intermédiaire.

11. Procédé selon l'une des revendications 7 à 10, caractérisé par le fait que la concentration du colorant échelonnée sur l'épaisseur de l'élément d'enregistrement va en diminuant du support à la surface extérieure de la couche d'enregistrement sensible à la lumière.

12. Procédé selon l'une des revendications 1 à 11, caractérisé par le fait que la couche d'enregistrement sensible à la lumière est formée d'un mélange photopolymérisable qui contient au moins un composé photopolymérisable, insaturé éthyléniquement et au moins un photoinitiateur.

13. Procédé selon l'une des revendications 1 à 12, caractérisé par le fait que la couche d'enregistrement sensible à la lumière est développable par voie aqueuse et contient au moins un liant polymère soluble ou au moins dispersable dans des solutions de développement aqueuses, au moins un composé à bas poids moléculaire, photopolymérisable, insaturé éthyléniquement, qui est compatible avec le liant polymère, et au moins un initiateur de photopolymérisation.

14. Procédé selon la revendication 13, caractérisé par le fait que la couche d'enregistrement sensible à la lumière contient, comme liant polymère, un polymérisat d'alcool vinylique ou un dérivé d'un polymérisat d'alcool vinylique.